# EUROPEAN PATENT APPLICATION

(11) **EP 4 687 141 A1**
(43) Date of publication of application: **04.02.2026**
(21) Application number: 25191472.7
(22) Date of filing: 24.07.2025
(51) Int. Cl.: G11C 7/10

(54) **MEMORY INCLUDING ZQ CALIBRATION CIRCUIT AND MEMORY DEVICE INCLUDING PLURALITY OF MEMORIES**

(30) Priority: 02.08.2024 KR 20240103445; 24.10.2024 KR 20240146977
(71) Applicant: Samsung Electronics Co., Ltd., Suwon-si, Gyeonggi-do 16677 (KR); Research & Business Foundation SUNGKYUNKWAN UNIVERSITY, Jangan-gu, Suwon-si Gyeonggi-do 16419 (KR)
(72) Inventor: SHIN, Dongho, 16677 Suwon-si (KR); KIM, Tongsung, 16677 Suwon-si (KR); KIM, Joonyoung, 16677 Suwon-si (KR); LEE, Kangyoon, 16677 Suwon-si (KR); LEE, Junha, Suwon-si (KR)
(74) Representative: Marks & Clerk LLP

(57) **Abstract**

Provided is a memory device including a plurality of memories and an impedance adjustment (ZQ) resistor, wherein a memory from among the plurality of memories includes a ZQ pin connected to the ZQ resistor, and a ZQ calibration circuit configured to perform a ZQ calibration operation, wherein the ZQ calibration circuit includes a driver, and a charge injection circuit, wherein the charge injection circuit includes a buffer and an AC coupling capacitor, is connected to the ZQ pin, and receives a charge injection signal. In response to a voltage level of a ZQ node being higher than a level of a reference voltage, the charge injection signal transitions from logic high to logic low, and, in response to the voltage level of the ZQ node being lower than the level of the reference voltage, the charge injection signal transitions from logic low to logic high.

## Description

### FIELD

The present disclosure relates to a semiconductor device, and more particularly, to a memory including an impedance adjustment (ZQ) calibration circuit and a memory device including a plurality of memories.

### BACKGROUND

Semiconductor memory devices may be classified into volatile memory devices such as static random-access memory (SRAM) and dynamic random-access memory (DRAM), which may lose stored data when power supply thereto is interrupted, and non-volatile memory devices such as flash memory devices, parallel random-access memory (PRAM), magnetoresistive random-access memory (MRAM), resistive random-access memory (RRAM), and ferroelectric random-access memory (FRAM), which retain stored data even when power supply thereto is interrupted.

Due to demands for increased operating speeds, increased data capacity, and reduced power consumption of electronic systems, semiconductor memories that may be accessed more quickly, store more data, and consume less power are being developed. A semiconductor memory may be generally controlled by providing commands, addresses, and clocks to a memory device. Various commands, addresses, and clocks may be provided by, for example, a memory controller. Commands may control the memory device to perform various memory operations, e.g., a read operation for retrieving data from the memory device and a write operation for storing data in the memory device. Data associated with commands may be provided between the memory controller and the memory device at known timings relative to reception and/or transmission by the memory device.

To minimize the transmission time of signals provided between a memory controller and a memory device, the signal swing width may be reduced. As the swing widths of signals decrease, the influence of external noise on a semiconductor chip may increase, and signal reflection caused by impedance mismatching at an interface may become serious. To resolve impedance mismatching, semiconductor chips may be equipped with an impedance adjustment (ZQ) pin, and an external resistor connected to the ZQ pin may be used to calibrate ZQ.

A memory controller may perform ZQ calibration operations on signal lines that transmit commands, addresses, and data to memory devices. The memory controller may perform a ZQ calibration operation to provide output driver resistance to each of the signal lines. The memory device may perform a ZQ calibration operation to provide on-die termination resistance to a signal pin connected to each of the signal lines. Signal lines between a memory controller and a memory device may carry signals having ideal input/output (IO) signal characteristics when the resistance of the memory controller matches the resistance of the memory device.

In addition, the memory device may include a number of data (DQ) pins that may be respectively connected to a plurality of DQ lines from among the signal lines. A ZQ calibration circuit includes a comparator necessary to implement resistance value adjustment of the DQ pins. The comparator may compare a reference voltage level with the voltage level of a ZQ pin and generate a pull-up code and/or a pull-down code that provides a resistance value of the DQ pins.

### SUMMARY

Provided is a memory including a ZQ calibration circuit with reduced ZQ calibration execution time and a memory device including a plurality of memories.

Additional aspects will be set forth in part in the description which follows and, in part, will be apparent from the description, or may be learned by practice of the presented embodiments.

In accordance with an aspect of the disclosure, a memory device includes: a plurality of memories; and an impedance adjustment (ZQ) resistor, wherein a memory from among the plurality of memories includes: a ZQ pin connected to the ZQ resistor; and a ZQ calibration circuit configured to perform a ZQ calibration operation, wherein the ZQ calibration circuit includes: a driver connected to the ZQ pin and connected to the ZQ resistor in series; and a charge injection circuit including a buffer and an alternating current (AC) coupling capacitor, wherein the charge injection circuit is connected to the ZQ pin, and is configured to receive a charge injection signal, wherein, based on a voltage level of a ZQ node connected to the ZQ pin being higher than a voltage level of a reference voltage, the charge injection signal transitions from a logic high value to a logic low value while a code is updated to the driver, for example while a code is updated and provided to the driver, and wherein, based on the voltage level of the ZQ node being lower than the voltage level of the reference voltage, the charge injection signal transitions from the logic low value to the logic high value while the code is updated to the driver, for example while the code is updated and provided to the driver.

In accordance with an aspect of the disclosure, a memory includes: an impedance adjustment (ZQ) pin connected to an external ZQ resistor; and a ZQ calibration circuit configured to perform a ZQ calibration operation, wherein the ZQ calibration circuit includes: a driver connected to the ZQ pin and the external ZQ resistor in series; and a charge injection circuit including a buffer and an AC coupling capacitor, wherein the charge injection circuit is connected to the ZQ pin, and wherein the charge injection circuit is configured to inject charges in a direction corresponding to a change direction of a voltage level of a ZQ node connected to the ZQ pin, for example wherein the charge injection circuit is configured to inject charges in a direction which increases a rate of change of the voltage level of the ZQ node connected to the ZQ pin.

In accordance with an aspect of the disclosure, a memory includes: an impedance adjustment (ZQ) pin connected to an external ZQ resistor; and a ZQ calibration circuit configured to perform a ZQ calibration operation, wherein the ZQ calibration circuit includes: a driver connected to the ZQ pin and the external ZQ resistor in series; a comparator configured to perform a comparison between a voltage level of a ZQ node and a voltage level of a reference voltage, and to output a comparison signal based on a result of the comparison; a charge injection circuit including a buffer and an AC coupling capacitor, wherein the charge injection circuit is connected to the ZQ pin; and a charge injection control circuit configured to output a charge injection signal to the charge injection circuit based on the comparison signal, wherein, based on the comparison signal indicating that a voltage level of the ZQ node is higher than the voltage level of the reference voltage, the charge injection signal transitions from a logic high value to a logic low value while a code is updated to the driver, for example while a code is updated and provided to the driver, and wherein, based on the comparison signal indicating that the voltage level of the ZQ node is lower than the voltage level of the reference voltage, the charge injection signal transitions from the logic low value to the logic high value while the code is updated to the driver, for example while a code is updated and provided to the driver.

At least some of the above and other features of the invention are set out in the claims.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a block diagram showing a memory system according to an embodiment;
FIG. 2 is a block diagram showing the memory device of FIG. 1 in more detail, according to an embodiment;
FIG. 3 is a circuit diagram showing the input/output circuit of FIG. 2 in more detail, according to an embodiment;
FIG. 4 is a block diagram showing the ZQ calibration circuit of FIG. 1 in more detail, according to an embodiment;
FIGS. 5A to 5D are circuit diagrams showing the charge injection circuit of FIG. 4 in more detail, according to an embodiment;
FIGS. 6A and 6B are diagrams illustrating the operation of the charge injection circuit of FIG. 5D, according to an embodiment;
FIG. 7 is a timing diagram illustrating the operation of the ZQ calibration circuit of FIG. 1, according to an embodiment;
FIG. 8 is a block diagram showing the ZQ calibration circuit of FIG. 1 in more detail, according to an embodiment;
FIG. 9 is a circuit diagram showing the first pull-up circuit of FIG. 8 in more detail, according to an embodiment;
FIG. 10 is a circuit diagram showing the charge injection circuit of FIG. 8 in more detail, according to an embodiment;
FIG. 11 is a timing diagram illustrating the operation of the ZQ calibration circuit of FIG. 8, according to an embodiment;
FIG. 12 is a block diagram showing the charge injection control circuit of FIG. 4 in more detail, according to an embodiment;
FIG. 13 is a block diagram showing a first sub-circuit of FIG. 12 in more detail, according to an embodiment;
FIG. 14 is a block diagram showing a second sub-circuit of FIG. 12 in more detail, according to an embodiment;
FIG. 15 is a block diagram showing the ZQ calibration circuit of FIG. 1 in more detail, according to an embodiment;
FIGS. 16A and 16B are drawings illustrating the effect of a charge injection operation, according to an embodiment;
FIG. 17 is a flowchart showing the operation of the ZQ calibration circuit of FIG. 1, according to an embodiment; and
FIG. 18 is a block diagram illustrating a system according to an embodiment.

### DETAILED DESCRIPTION OF EMBODIMENTS

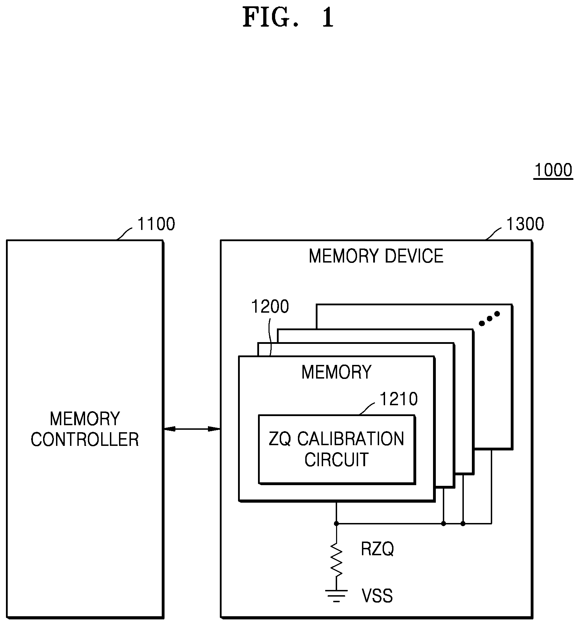

FIG. 1 is a block diagram showing a memory system according to an embodiment.

Referring to FIG. 1, a memory system 1000 may include a memory controller 1100 and a memory device 1300. The memory device 1300 may include a plurality of memories 1200 and an external resistor RZQ (or an impedance adjustment (ZQ) resistor). Each memory 1200 may be configured similarly or identically to, and operate in the same manner as, at least one other memory 1200 included in the plurality of memories 1200. Each memory 1200 may include a ZQ calibration circuit 1210.

A ZQ pin of a first memory from among the plurality of memories 1200 may be connected to the external resistor RZQ, and a ZQ pin of a second memory from among the plurality of memories 1200 may be connected to the external resistor RZQ. The plurality of memories 1200 may share the external resistor RZQ. The external resistor RZQ may be connected to a ground node, which may refer to a node of a ground voltage VSS.

The memory controller 1100 may control the memory device 1300. For example, the memory controller 1100 may transmit an address ADDR, a command CMD, and a control signal CTRL to the memory device 1300 to control the memory device 1300 and may exchange data DATA with the memory device 1300. According to an embodiment, the memory controller 1100 may be a system-on-chip (SoC), such as an application processor (AP).

For example, the memory controller 1100 may be implemented by, or otherwise include, an integrated circuit (IC), an SoC, an application processor (AP), a mobile AP, a chipset, or a set of chips. According to an embodiment, the memory controller 1100 may be a semiconductor device, and the memory controller 1100 may be a component included in an AP. An AP may include a memory controller, random access memory (RAM), a central processing unit (CPU), a graphics processing unit (GPU), and/or a modem.

According to an embodiment, the memory device 1300 may be implemented by, but is not limited to, at least one of a dynamic RAM (DRAM) and a static RAM (SRAM). For example, the memory device 1300 may correspond to at least one of a double data rate synchronous dynamic random access memory (DDR SDRAM), low power double data rate LPDD (LPDDR) SDRAM, graphics double data rate (GDDR) SDRAM, Rambus dynamic random access memory (RDRAM), etc. In some embodiments, the memory device 1300 may be implemented by a high bandwidth memory (HBM) or a Processor In Memory (PIM).

According to an embodiment, the memory device 1300 may also be implemented as a non-volatile memory device. For example, the memory device 1300 may be implemented as flash memory or resistive memory, such as at least one of a phase change RAM (PRAM), magnetic RAM (MRAM), and a resistive RAM (RRAM).

The memory device 1300 may operate under the control of the memory controller 1100. For example, the memory device 1300 may store data or provide stored data to the memory controller 1100, in response to signals received from the memory controller 1100. According to an embodiment, when an action or operation is referred to as occurring "in response to" an event or occurrence, this may mean that action or operation occurs directly or indirectly in response to, or based on, the event or occurrence.

According to an embodiment, the memory controller 1100 and the memory device 1300 may communicate with each other based on a predetermined interface. The predetermined interface may be an LPDDR interface. However, the scope of the disclosure is not limited thereto, and the predetermined interface may include at least one of various interfaces, such as at least one of a toggle interface, an open NAND flash interface (ONFI), a double data rate (DDR), a universal serial bus (USB), a multimedia card (MMC), a peripheral component interconnection (PCI), a PCI-express (PCI-E), an advanced technology attachment (ATA), a serial-ATA (SATA), a parallel-ATA (PATA), a small computer small interface (SCSI), an enhanced small disk interface (ESDI), an integrated drive electronics (IDE), a mobile industry processor interface (MIPI), and a non-volatile Memory-express (NVM-e).

A memory 1200 may include the ZQ calibration circuit 1210. The ZQ calibration circuit 1210 may perform a ZQ calibration operation. According to an embodiment, ZQ calibration may refer to at least one of an operation that includes adjusting the strength of output drivers connected to a data (DQ) line or another signal line (e.g., a command/address line CA) of the memory 1200 and an operation that includes setting an on-die termination (ODT) value. The memory 1200 may perform the ZQ calibration described above using the external resistor RZQ (which may be referred to as a ZQ resistor).

The memory device 1300 may be or may include a multi-die package. The memory device 1300 may be implemented as a single semiconductor package or a multi-die package. According to an embodiment, the external resistor RZQ may be formed on a substrate on which a semiconductor package is mounted. According to an embodiment, the plurality of memories 1200 may share one external resistor RZQ. The loading capacitance value of a ZQ node nZQ connected to the plurality of memories 1200 may increase. The voltage change rate of the ZQ node nZQ may be reduced. Due to the reduced voltage change rate of the ZQ node nZQ, the time needed to perform ZQ calibration may increase. Due to an increase in the loading capacitance value of the ZQ node nZQ, the ZQ calibration operation may not be performed properly.

The ZQ calibration circuit 1210 according to an embodiment may perform a charge injection operation. The charge injection operation may refer to an operation that includes injecting charges in the same direction as a direction of the change in the voltage level of a ZQ node connected to a ZQ pin, for example the charge injection operation may refer to an operation that includes injecting charges in a direction which increases a rate of change in the voltage level of a ZQ node connected to a ZQ pin. According to an embodiment, the direction of the change in the voltage level of the ZQ node may be referred to as a change direction. The ZQ calibration circuit 1210 may perform a charge injection operation using an alternating current (AC) coupling capacitor. Therefore, the memory system 1000 may improve the ZQ calibration execution time in a multi-die package. Also, the memory system 1000 may improve ZQ characteristics (or signal integrity (SI) characteristics) in a multi-die package. As a result, a memory device with improved performance may be provided.

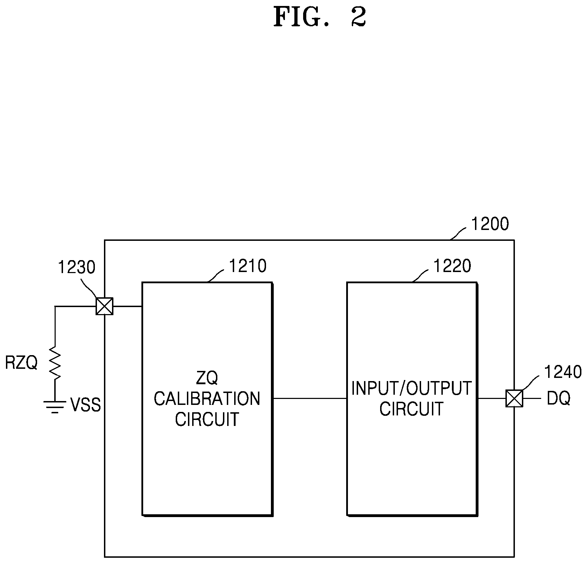

FIG. 2 is a block diagram showing the memory of FIG. 1 in more detail.

Referring to FIGS. 1 and 2, the memory 1200 may include the ZQ calibration circuit 1210, an input/output circuit 1220, a ZQ pin 1230, and a DQ pin 1240. The memory 1200 may include a plurality of input/output pins. The plurality of input/output pins may include data pins (which may be referred to as DQ pins) and impedance adjustment pins (which may be referred to as ZQ pins). According to an embodiment, the plurality of input/output pins may further include command pins and address pins. The memory 1200 may perform a ZQ calibration operation. The memory 1200 may use the ZQ pin 1230 (or a ZQ pad) to connect the external resistor RZQ.

According to an embodiment, the memory 1200 may include a plurality of DQ pins. For simplicity, only one DQ pin 1240 among the plurality of DQ pins is illustrated in FIG. 2. The ZQ pin 1230 may be connected to the ground voltage VSS through the external resistor RZQ, which may be provided on a memory module substrate or a motherboard. The external resistor RZQ may correspond to a reference resistance used during a ZQ calibration operation that may be, for example, about 300 Ω. The DQ pin 1240 may transmit data DQ read from a memory cell of the memory 1200 to the memory controller 1100 and receive data DQ to be written to a memory cell from the memory controller 1100. FIG. 2 illustrates an example in which the ZQ pin 1230 is external to the ZQ calibration circuit 1210, but embodiments are not limited thereto, and the ZQ pin 1230 may be included in the ZQ calibration circuit 1210.

FIG. 2 shows a number of conceptual hardware components included in the memory 1200. However, embodiments are not limited thereto, and other components may be provided. The input/output circuit 1220 may transmit and receive data through a plurality of DQ pins including the DQ pin 1240. The input/output circuit 1220 may transmit and receive data through DQ lines respectively connected to a plurality of DQ pins. FIG. 2 illustrates an example in which the DQ pin 1240 is outside the input/output circuit 1220, but embodiments are not limited thereto, and the DQ pin 1240 may be included in the input/output circuit 1220.

The input/output circuit 1220 may provide a termination resistance value of the DQ pin 1240, based on a code signal provided from the ZQ calibration circuit 1210. Due to the input/output circuit 1220, a pull-up termination resistance value and/or a pull-down termination resistance value of the DQ pin 1240 may be controlled in response to code signals. The input/output circuit 1220 may include pull-up driver circuits and pull-down driver circuits, each including heterogeneous transistors.

The ZQ calibration circuit 1210 may perform a calibration operation using the external resistor RZQ and a reference voltage Vref. The calibration operation may include a pull-up calibration operation and a pull-down calibration operation. The ZQ calibration circuit 1210 may provide a code signal to the input/output circuit 1220.

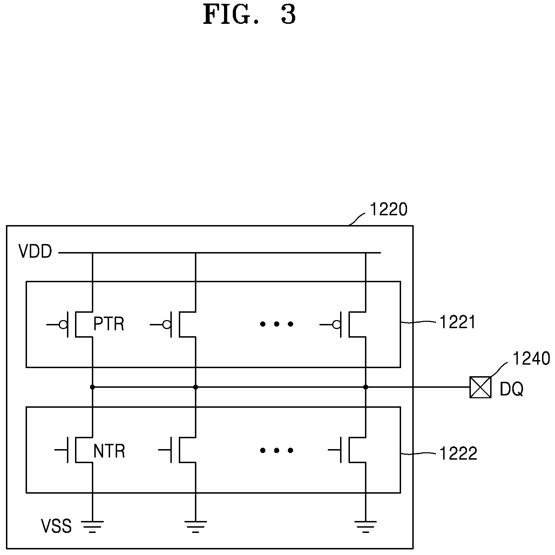

FIG. 3 is a circuit diagram showing the input/output circuit of FIG. 2 in more detail.

Referring to FIGS. 2 and 3, the input/output circuit 1220 may include a pull-up driver circuit 1221 connected between a line having a power voltage VDD and the DQ pin 1240 and a pull-down driver circuit 1222 connected between the DQ pin 1240 and a line having a ground voltage VSS. According to an embodiment, the line having the power voltage VDD may be referred to as a power node, and the line having the ground voltage VSS may be referred to as a ground node. The pull-up driver circuit 1221 may include a plurality of PMOS transistors PTR arranged in parallel and connected between the line having the power voltage VDD and the DQ pin 1240. The plurality of PMOS transistors PTR may each be turned on or off in response to a code signal of corresponding n bits. According to an embodiment, turning on a transistor may be referred to as activating the transistor, and a transistor that is turned on may be referred to as being activated. Similarly, turning off a transistor may be referred to as deactivating the transistor, and a transistor that is turned off may be referred to as being deactivated. According to an embodiment, the plurality of PMOS transistors PTR may have the same or different size ratios with respect to the width of a transistor. Resistance values according to the on/off state (e.g., the activated/deactivated state) of the PMOS transistors PTR included in the pull-up driver circuit 1221 may be provided as the pull-up termination resistance of the DQ pin 1240.

The pull-down driver circuit 1222 may include a plurality of NMOS transistors NTR arranged in parallel and connected between the DQ pin 1240 and the line of the ground voltage VSS. The NMOS transistors NTR may be turned on or off in response to a code signal of corresponding n bits. According to an embodiment, the plurality of NMOS transistors NTR may have the same or different size ratios with respect to the width of a transistor. The resistance values according to the on/off state of the NMOS transistors NTR may be provided as the pull-down termination resistance of the DQ pin 1240.

According to an embodiment, the input/output circuit 1220 may receive a code signal from the ZQ calibration circuit 1210. For example, the code signal may include a first code and a second code. The first code may be a pull-up code. The second code may be a pull-down code. The pull-up driver circuit 1221 may receive the first code. PMOS transistors PTR included in the pull-up driver circuit 1221 may be turned on or off in response to the first code. The pull-down driver circuit 1222 may receive the second code. NMOS transistors NTR of the pull-down driver circuit 1222 may be turned on or off in response to the second code.

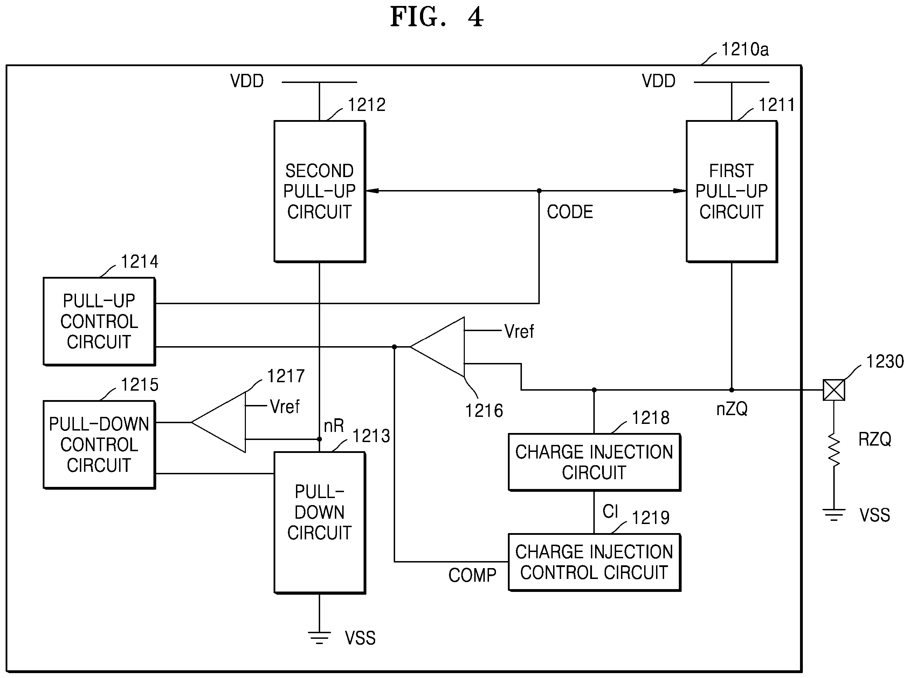

FIG. 4 is a block diagram showing the ZQ calibration circuit of FIG. 1 in more detail.

A ZQ calibration circuit 1210a of FIG. 4 may correspond to the ZQ calibration circuit 1210 of FIG. 1. In embodiments below, letters appended to reference numerals (e.g., "a", "b", and "c") may be used to identify a plurality of circuits having the same function.

Referring to FIG. 4, the ZQ calibration circuit 1210a may include a first pull-up circuit 1211 (which may be referred to as a first pull-up driver circuit), a second pull-up circuit 1212 (which may be referred to as a second pull-up driver circuit), a pull-down circuit 1213 (which may be referred to as a pull-down driver circuit), a pull-up control circuit 1214, a pull-down control circuit 1215, a first comparator 1216, a second comparator 1217, a charge injection circuit 1218, and a charge injection control circuit 1219. The first pull-up circuit 1211 may be connected between a power node to which the power voltage VDD is applied (e.g., a line of the power voltage VDD) and the ZQ pin 1230. For example, the first pull-up circuit 1211 and the external resistor RZQ may be connected in series between the power node to which the power voltage VDD is applied and a ground node to which the ground voltage VSS is applied (e.g., a line of the ground voltage VSS). The second pull-up circuit 1212 and the pull-down circuit 1213 may be connected in series between the power node to which a first power voltage VDD is applied and a ground node to which the ground voltage VSS is applied.

In the description below, the terms "pull-up circuit" and "driver" may be used interchangeably. Also, the terms "pull-down circuit" and "driver" may be used interchangeably. These terms may have the same or different meanings depending on the contexts of embodiments, and the meaning of each term will be understood according to the context of embodiments being described.

According to an embodiment, the first pull-up circuit 1211 and the second pull-up circuit 1212 may have substantially the same configuration as the pull-up driver circuit 1221 of FIG. 3, and the pull-down circuit 1213 may have substantially the same configuration as the pull-down driver circuit 1222 of FIG. 3.

The first comparator 1216 may compare the voltage level of the ZQ node nZQ connected to a ZQ pin 1230 with the voltage level of the reference voltage Vref and generate a comparison signal COMP based on a comparison result. The first comparator 1216 may output the comparison result as the comparison signal COMP. For example, the comparison signal COMP may be an up/down signal. The comparison signal COMP may indicate, e.g., up or down. The reference voltage Vref may be set to a value that provides target impedance for pull-up circuits (e.g., the first pull-up circuit 1211 and the second pull-up circuit 1212). For example, the reference voltage Vref may have a voltage level corresponding to half of the level of the power voltage VDD (e.g., VDD/2) or another voltage (e.g., VDD/3).

The pull-up control circuit 1214 may output a multi-bit count value (e.g., a code) based on a comparison signal of the first comparator 1216. The pull-up control circuit 1214 may generate a code based on the comparison signal. The pull-up control circuit 1214 may provide a code to the pull-up circuits (e.g., the first pull-up circuit 1211 and the second pull-up circuit 1212). The pull-up circuits (e.g., the first pull-up circuit 1211 and the second pull-up circuit 1212) may increase or decrease the voltage level of the ZQ node nZQ based on the code received from the pull-up control circuit 1214.

According to an embodiment, the pull-up circuits (e.g., the first pull-up circuit 1211 and the second pull-up circuit 1212) may each include a plurality of PMOS transistors connected between a line of the power voltage VDD and the ZQ node nZQ. However, embodiments are not limited thereto, and the pull-up circuits(e.g., the first pull-up circuit 1211 and the second pull-up circuit 1212) may each include a plurality of PMOS transistors and resistors connected between a plurality of lines of the power voltage VDD and the ZQ node nZQ. For example, a resistor may be made of or include a tungsten wire or an aluminum wire between the PMOS transistors and the ZQ node nZQ.

The first comparator 1216 may perform a comparison operation until the voltage level of the ZQ node nZQ and the voltage level of the reference voltage Vref are the same or within a certain value and/or the pull-up control circuit 1214 enters a dither condition in which it oscillates between step-up and step-down. In the pull-up calibration operation, the pull-up control circuit 1214 may provide a code as a first code to each of the pull-up circuits (e.g., the first pull-up circuit 1211 and the second pull-up circuit 1212) based on a comparison result indicating that the voltages are the same or that the difference between the voltages is within a particular range, and/or based on the comparison result reaching a dither condition. The pull-up termination resistance of each of the pull-up circuits (e.g., the first pull-up circuit 1211 and the second pull-up circuit 1212) may be adjusted by the first code.

The second pull-up circuit 1212 may be connected to the pull-down circuit 1213. The second comparator 1217 may compare the voltage level of a replica node nR between the second pull-up circuit 1212 and the pull-down circuit 1213 with the voltage level of the reference voltage Vref and generate an up/down signal based on a comparison result. In embodiments, the voltage level of the replica node may replicate the voltage level of the ZQ node nZQ, but embodiments are not limited thereto. The pull-down control circuit 1215 may output a code by stepping up or down based on the up/down signal of the second comparator 1217. A code of the pull-down control circuit 1215 may be provided to the pull-down circuit 1213, and the pull-down circuit 1213 may be operated based on the code received from the pull-down control circuit 1215.

The pull-down circuit 1213 may have substantially the same configuration as the pull-down driver circuit 1222 of FIG. 3. The pull-down circuit 1213 may perform a pull-down calibration operation until the voltage level of a connection node (e.g., the replica node nR) between the second pull-up circuit 1212 and the pull-down circuit 1213 and the voltage level of the reference voltage Vref become equal to each other as sensed by the second comparator 1217. At a point when the voltage level of the connection node between the second pull-up circuit 1212 and the pull-down circuit 1213 and the voltage level of the reference voltage Vref become equal to each other, the code of the pull-down control circuit 1215 may be provided as the second code. The pull-down termination resistance of the pull-down circuit 1213 may be adjusted by the second code.

The charge injection circuit 1218 may be connected to the ZQ node nZQ. The charge injection circuit 1218 may be connected to the ZQ pin 1230. According to an embodiment, the charge injection circuit 1218 may perform a charge injection operation. The charge injection operation may refer to an operation that includes injecting charges in the same direction as the change in the voltage level of a ZQ node nZQ, for example the charge injection operation may refer to an operation that includes injecting charges in a direction which increases a rate of change in the voltage level of a ZQ node. The charge injection circuit 1218 may perform a charge injection operation through an AC coupling capacitor.

The charge injection circuit 1218 may receive a charge injection signal CI. The charge injection circuit 1218 may perform a charge injection operation in response to the charge injection signal CI. The charge injection circuit 1218 may inject charges through an AC coupling capacitor while the voltage level of the ZQ node nZQ is rising or falling.

According to an embodiment, in response to the voltage level of the ZQ node nZQ connected to the ZQ pin 1230 being higher than the voltage level of the reference voltage Vref, the charge injection signal CI may transition from a logic high value to a logic low value while a code is being updated to the first pull-up circuit 1211, for example while a code is being updated and provided to the first pull-up circuit 1211. In response to the voltage level of the ZQ node nZQ being lower than the voltage level of the reference voltage Vref, the charge injection signal CI may transition from logic low to logic high while the code is being updated to the first pull-up circuit 1211, for example while the code is being updated and provided to the first pull-up circuit 1211.

The charge injection control circuit 1219 may control the operation of the charge injection circuit 1218. The charge injection control circuit 1219 may generate a signal and a clock signal for driving the charge injection circuit 1218. The charge injection control circuit 1219 may provide a signal and a clock signal to the charge injection circuit 1218.

According to an embodiment, the charge injection control circuit 1219 may receive the comparison signal COMP from the first comparator 1216. The charge injection control circuit 1219 may generate the charge injection signal CI. The charge injection control circuit 1219 may generate the charge injection signal CI based on the comparison signal COMP. The charge injection control circuit 1219 may transmit (or, for example, output or provide) the charge injection signal CI to the charge injection circuit 1218.

According to an embodiment, the charge injection control circuit 1219 may generate an enable signal CIEN. The charge injection control circuit 1219 may provide the enable signal CIEN to the charge injection circuit 1218. For example, the charge injection control circuit 1219 may output the enable signal CIEN having a logic high value to the charge injection circuit 1218 while the code is being updated to the first pull-up circuit 1211. According to an embodiment, the charge injection control circuit 1219 may provide an inverted enable signal CIENB, which may be a complement of the enable signal CIEN, to the charge injection circuit 1218.

As described above, the ZQ calibration circuit 1210a may improve the voltage change rate of the ZQ node nZQ by injecting additional charges into the ZQ node nZQ through the AC coupling capacitor.

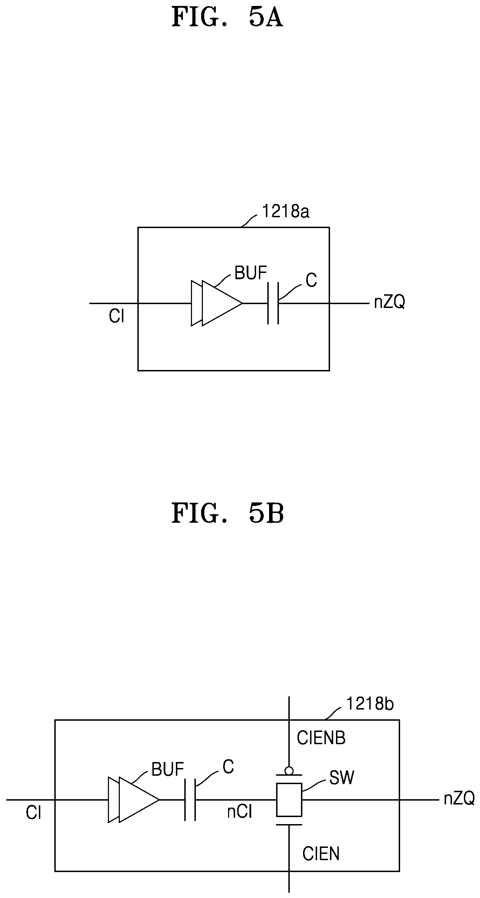

FIGS. 5A to 5D are circuit diagrams showing examples of the charge injection circuit of FIG. 4 in more detail. Each of the charge injection circuits illustrated in FIGS. 5A to 5D may correspond to the charge injection circuit 1218 of FIG. 4.

Referring to FIG. 5A, a charge injection circuit 1218a may include a buffer BUF and a capacitor C. For example, the capacitor C may be an AC coupling capacitor. The capacitor C may be connected between the buffer BUF and the ZQ node nZQ. The buffer BUF and the capacitor C may be connected in series. An output of the buffer BUF may be connected to the capacitor C.

The buffer BUF may receive the charge injection signal CI from the charge injection control circuit 1219. The buffer BUF may transfer the charge injection signal CI to the capacitor C. For example, the buffer BUF may include a plurality of inverters. The buffer BUF may include a plurality of transistors.

Referring to FIG. 5B, a charge injection circuit 1218b may include the buffer BUF, the capacitor C, and a switch SW. For example, the capacitor C may be an AC coupling capacitor. The switch SW may be connected between the ZQ node nZQ and the capacitor C. The switch SW may be connected between the ZQ node nZQ and a charge injection node nCI. The capacitor C may be connected between the buffer BUF and the switch SW. The buffer BUF, the capacitor C, and the switch SW may be connected in series. An output of the buffer BUF may be connected to the capacitor C.

The buffer BUF may receive the charge injection signal CI from the charge injection control circuit 1219. The buffer BUF may transfer the charge injection signal CI to the capacitor C. The switch SW may selectively connect the charge injection node nCI and the ZQ node nZQ. The switch SW may operate in response to the enable signal CIEN (or an inverted enable signal CIENB). According to an embodiment, the switch SW may be implemented using of a transmission gate with an NMOS transistor and a PMOS transistor connected in parallel. However, embodiments are not limited thereto, and the switch SW may be implemented using various elements configured to block or allow electrical connection between the capacitor C and the ZQ node nZQ in response to the enable signal CIEN or the inverted enable signal CIENB. For example, the switch SW may be an NMOS transistor and may operate in response to the enable signal CIEN. For example, in response to the enable signal CIEN having an active level (e.g., a level corresponding to a logic high value), the NMOS transistor of the switch SW may be turned on or activated.

According to an embodiment, when the switch SW is turned on (or enabled, or activated), the capacitor C and the ZQ node nZQ may be electrically connected to each other. When the switch SW is turned off (or disabled, or deactivated), the capacitor C and the ZQ node nZQ may be electrically disconnected.

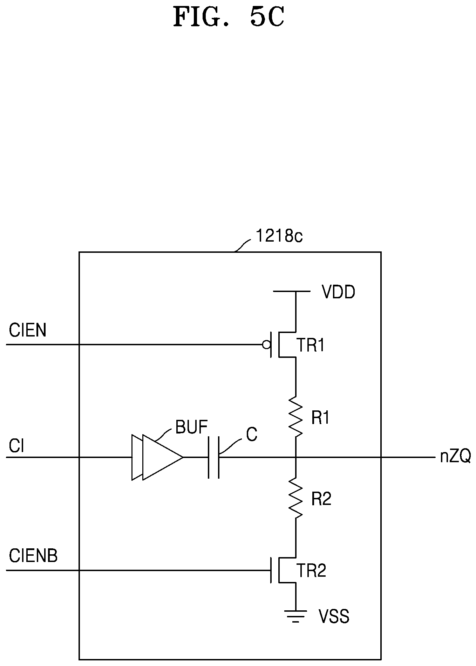

Referring to FIG. 5C, a charge injection circuit 1218c may include the buffer BUF, the capacitor C, a first transistor TR1, a second transistor TR2, a first resistor R1, and a second resistor R2. For example, the capacitor C may be an AC coupling capacitor. The charge injection circuit 1218c may receive the charge injection signal CI, the enable signal CIEN, and the inverted enable signal CIENB from the charge injection control circuit 1219.

The capacitor C may be connected between the buffer BUF and the ZQ node nZQ. The buffer BUF and the capacitor C may be connected in series. An output of the buffer BUF may be connected to the capacitor C. The buffer BUF may receive the charge injection signal CI from the charge injection control circuit 1219. The buffer BUF may transfer the charge injection signal CI to the capacitor C.

The first transistor TR1 may be connected between a power node to which the power voltage VDD is applied and the first resistor R1. The first transistor TR1 may operate in response to the enable signal CIEN. The first transistor TR1 may be a PMOS transistor. However, embodiments are not limited thereto.

According to an embodiment, in response to the enable signal CIEN having an inactive level (e.g., a level corresponding to a logic low value), the first transistor TR1 may be turned on. The first transistor TR1 may be turned on to electrically connect a power node to which a power voltage VDD is applied and the first resistor R1. The first transistor TR1 may be turned off in response to the enable signal CIEN having an active level. The first transistor TR1 may be turned off to electrically disconnect a power node to which a power voltage VDD is applied and the first resistor R1.

The first resistor R1 may be connected between the first transistor TR1 and the ZQ node nZQ. The first resistor R1 may be connected between the first transistor TR1 and the second resistor R2. The second resistor R2 may be connected between the ZQ node nZQ and the second transistor TR2. The second resistor R2 may be connected between the first resistor R1 and the second transistor TR2.

According to an embodiment, the resistance value of the first resistor R1 and the resistance value of the second resistor R2 may be the same. According to an embodiment, the resistance value of the first resistor R1 may be different from the resistance value of the second resistor R2. For example, the resistance value of the first resistor R1 may be twice the resistance value of the second resistor R2.

The second transistor TR2 may be connected between a ground node to which the ground voltage VSS is applied and the second resistor R2. The second transistor TR2 may operate in response to the inverted enable signal CIENB. The second transistor TR2 may be an NMOS transistor. However, embodiments are not limited thereto.

According to an embodiment, in response to the inverted enable signal CIENB having an active level, the second transistor TR2 may be turned on. The second transistor TR2 may be turned on to electrically connect a ground node to which the ground voltage VSS is applied and the second resistor R2. The second transistor TR2 may be turned off in response to the inverted enable signal CIENB having an inactive level. The second transistor TR2 may be turned off to electrically disconnect the ground node to which the ground voltage VSS is applied and the second resistor R2.

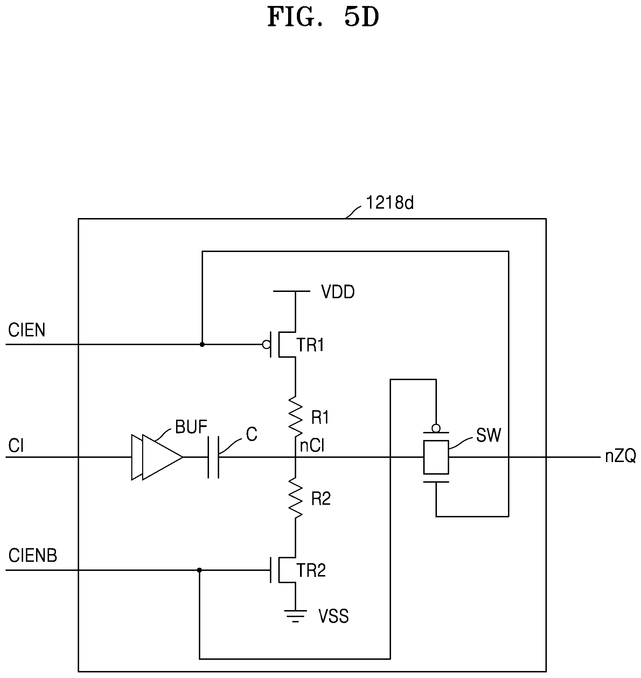

Referring to FIG. 5D, a charge injection circuit 1218d may include the buffer BUF, the capacitor C, the first transistor TR1, the second transistor TR2, the first resistor R1, the second resistor R2, and the switch SW. For example, the capacitor C may be an AC coupling capacitor. The charge injection circuit 1218d may receive the charge injection signal CI, the enable signal CIEN, and the inverted enable signal CIENB from the charge injection control circuit 1219.

The switch SW may be connected between the ZQ node nZQ and the capacitor C. The capacitor C may be connected between the buffer BUF and the switch SW. The buffer BUF, the capacitor C, and the switch SW may be connected in series. An output of the buffer BUF may be connected to the capacitor C. The buffer BUF may receive the charge injection signal CI from the charge injection control circuit 1219. The buffer BUF may transfer the charge injection signal CI to the capacitor C.

The switch SW may operate in response to the enable signal CIEN (or an inverted enable signal CIENB). According to an embodiment, the switch SW may be implemented using a transmission gate with an NMOS transistor and a PMOS transistor connected in parallel. However, embodiments are not limited thereto, and the switch SW may be implemented using various elements configured to block or allow electrical connection between the capacitor C and the ZQ node nZQ in response to the enable signal CIEN. For example, the switch SW may be an NMOS transistor and may operate in response to the enable signal CIEN. For example, in response to the enable signal CIEN being enabled (e.g., having an active level or level corresponding to a logic high value), the NMOS transistor of the switch SW may be turned on. By enabling the enable signal CIEN, the capacitor C and the ZQ node nZQ may be electrically connected to each other.

According to an embodiment, when the switch SW is turned on, the capacitor C and the ZQ node nZQ may be electrically connected to each other. When the switch SW is turned off, the capacitor C and the ZQ node nZQ may be electrically disconnected.

The first transistor TR1 may be connected between a power node to which the power voltage VDD is applied and the first resistor R1. The first transistor TR1 may operate in response to the enable signal CIEN. The first transistor TR1 may be a PMOS transistor. However, embodiments are not limited thereto.

According to an embodiment, in response to the enable signal CIEN having an inactive level, the first transistor TR1 may be turned on. The first transistor TR1 may be turned on to electrically connect a power node to which a power voltage VDD is applied and the first resistor R1. The first transistor TR1 may be turned off in response to the enable signal CIEN having an active level. The first transistor TR1 may be turned off to electrically disconnect a power node to which a power voltage VDD is applied and the first resistor R1.

The first resistor R1 may be connected between the first transistor TR1 and the ZQ node nZQ. The first resistor R1 may be connected between the first transistor TR1 and the second resistor R2. The second resistor R2 may be connected between the ZQ node nZQ and the second transistor TR2. The second resistor R2 may be connected between the first resistor R1 and the second transistor TR2.

According to an embodiment, the resistance value of the first resistor R1 may be the same as the resistance value of the second resistor R2. According to an embodiment, the resistance value of the first resistor R1 may be different from the resistance value of the second resistor R2. For example, the resistance value of the first resistor R1 may be twice the resistance value of the second resistor R2.

The second transistor TR2 may be connected between a ground node to which the ground voltage VSS is applied and the second resistor R2. The second transistor TR2 may operate in response to the inverted enable signal CIENB. The second transistor TR2 may be an NMOS transistor. However, embodiments are not limited thereto.

According to an embodiment, in response to the inverted enable signal CIENB having an active level, the second transistor TR2 may be turned on. The second transistor TR2 may be turned on to electrically connect a ground node to which the ground voltage VSS is applied and the second resistor R2. The second transistor TR2 may be turned off in response to the inverted enable signal CIENB having an inactive level. The second transistor TR2 may be turned off to electrically disconnect the ground node to which the ground voltage VSS is applied and the second resistor R2.

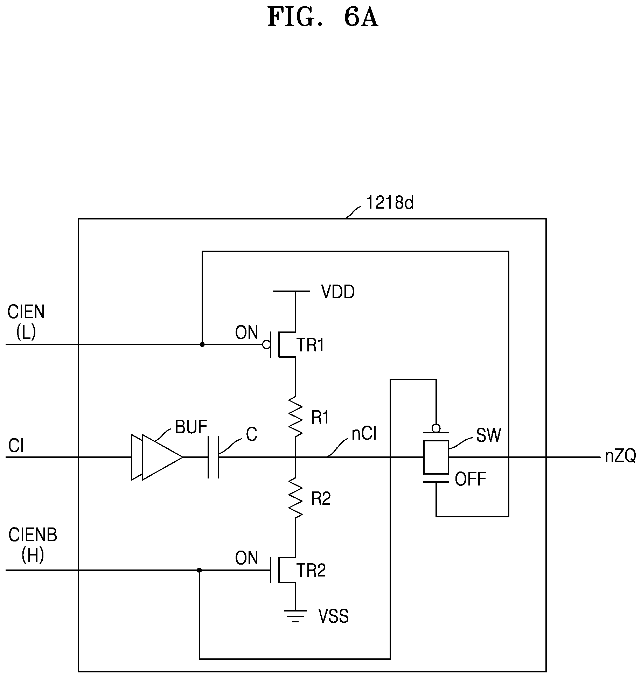

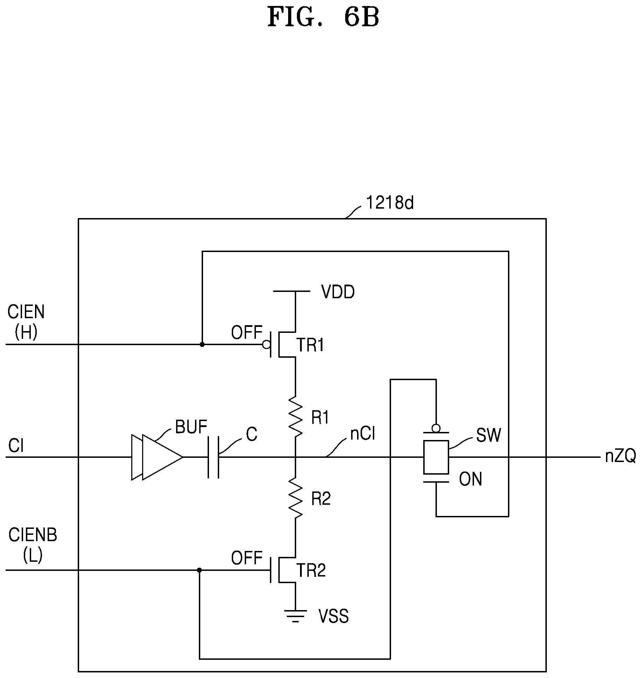

FIGS. 6A and 6B are diagrams illustrating the operation of the charge injection circuit of FIG. 4.

Referring to FIG. 5D and FIG. 6A, the enable signal CIEN may have an inactive level (e.g., a level corresponding to a logic low value L) and the inverted enable signal CIENB may have an active level (e.g., a level corresponding to a logic high value H). According to an embodiment, in response to the enable signal CIEN having an inactive level, the charge injection circuit 1218 may be disabled. In response to the enable signal CIEN having the inactive level, the first transistor TR1 may be turned on. The first transistor TR1 may electrically connect a power node to the first resistor R1. In response to the inverted enable signal CIENB having the active level, the second transistor TR2 may be turned on. The second transistor TR2 may electrically connect a ground node to the second resistor R2. In response to the enable signal CIEN having the inactive level and the inverted enable signal CIENB having the active level, the switch SW may be turned off. The switch SW may block the electrical connection between the capacitor C and the ZQ node nZQ.

In response to the enable signal CIEN having an inactive level, the charge injection circuit 1218 may be disabled. While the charge injection circuit 1218 is being inactive, to minimize the charge sharing effect with a charge injection node (e.g., a point between the capacitor C and the switch SW) and the ZQ node nZQ, a charge injection node may be maintained at a voltage corresponding to a ratio between the first resistor and the second resistor (e.g., the reference voltage Vref).

Referring to FIG. 5D and FIG. 6B, the enable signal CIEN may have the active level and the inverted enable signal CIENB may have the inactive level . According to an embodiment, in response to the enable signal CIEN having an active level, the charge injection circuit 1218 may be enabled. In response to the enable signal CIEN having the active level, the first transistor TR1 may be turned off. The first transistor TR1 may electrically block a power node and the first resistor R1. In response to the inverted enable signal CIENB having the inactive level, the second transistor TR2 may be turned off. The second transistor TR2 may electrically block a ground node and the second resistor R2. In response to the enable signal CIEN having the active level and the inverted enable signal CIENB having the inactive level, the switch SW may be turned on. The switch SW may electrically connect between the capacitor C and the ZQ node nZQ.

In response to the enable signal CIEN having an active level, the charge injection circuit 1218 may be enabled. While the charge injection circuit 1218 is being active, charges may be injected into the ZQ node nZQ. While a code is being updated to the first pull-up circuit 1211, the charge injection control circuit 1219 may provide the charge injection signal CI to the charge injection circuit 1218. The charge injection circuit 1218 may inject charges into the ZQ node nZQ in response to the charge injection signal CI. The charge injection circuit 1218 may inject charge according to a direction of change in the voltage level of the ZQ node nZQ.

According to an embodiment, when the charge injection circuit 1218 is enabled, the first transistor TR1 and the second transistor TR2 are turned off, and thus the first resistor R1 and the second resistor R2 may not affect the ZQ node nZQ.

As described above, while the charge injection circuit 1218 is performing a charge injection operation that injects charges in the direction in which the voltage level of the ZQ node nZQ changes (e.g., when the charge injection circuit is enabled) for example while the charge injection circuit 1218 is performing a charge injection operation that injects charges in a direction which increases a rate of change of the voltage level of the ZQ node nZQ, the first transistor TR1 may be turned off, the second transistor TR2 may be turned off, and the switch SW may be turned on. While the charge injection circuit 1218 is not performing a charge injection operation (e.g., when the charge injection circuit is disabled), the first transistor TR1 may be turned on, the second transistor TR2 may be turned on, and the switch SW may be turned off. When the charge injection circuit 1218 is disabled, to minimize the charge sharing effect with the charge injection node nCI (e.g., a node between the capacitor C and the switch SW) and the ZQ node nZQ, the charge injection node nCI may be maintained at a voltage corresponding to a ratio between the first resistor R1 and the second resistor R2 (e.g., the reference voltage Vref).

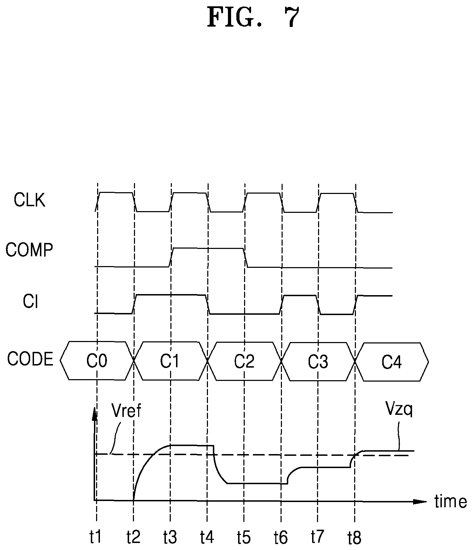

FIG. 7 is a timing diagram illustrating the operation of the ZQ calibration circuit of FIG. 1.

Referring to FIGS. 1, 4, and 7, the ZQ calibration circuit 1210 may perform a ZQ calibration operation. The ZQ calibration circuit 1210 may perform a charge injection operation while performing the ZQ calibration operation.

The first comparator 1216 may compare the voltage level of the ZQ node nZQ (illustrated as Vzq) connected to the ZQ pin 1230 with the voltage level of the reference voltage Vref and generate a comparison signal COMP based on a comparison result. According to an embodiment, when the voltage level of the ZQ node nZQ is greater than the voltage level of the reference voltage Vref, the first comparator 1216 may output the comparison signal COMP having a logic high value H. When the voltage level of the ZQ node nZQ is lower than the voltage level of the reference voltage Vref, the first comparator 1216 may output the comparison signal COMP having a logic low value L. However, embodiments are not limited thereto. When the voltage level of the ZQ node nZQ is higher than that of the reference voltage Vref, the first comparator 1216 may output the comparison signal COMP having a logic low value L, and, when the voltage level of the ZQ node nZQ is higher than the voltage level of the reference voltage Vref, the first comparator 1216 may output the comparison signal COMP having a logic high value H.

FIG. 7 illustrates an example in which the comparison signal COMP having the level corresponding to a logic high value H indicates that the voltage level of the ZQ node nZQ is greater than the voltage level of the reference voltage Vref, and the comparison signal COMP having a level corresponding to a logic low value L indicates that the voltage level of the ZQ node nZQ is less than the voltage level of the reference voltage Vref. However, embodiments are not limited thereto.

In the example described below, the voltage level of a voltage Vzq of the ZQ node nZQ is lower than the voltage level of the reference voltage VREF at a first time point t1, the voltage level of the voltage Vzq of the ZQ node nZQ is higher than the voltage level of the reference voltage VREF at a third time point t3, the voltage level of the voltage Vzq of the ZQ node nZQ is lower than the voltage level of the reference voltage VREF at a fifth time point t5, and the voltage level of the voltage Vzq of the ZQ node nZQ is lower than the voltage level of the reference voltage VREF at a seventh time point t7. A 0-th pull-up code C0 may be a predetermined code or a default code.

At the first time point t1, because the voltage level of the voltage Vzq of the ZQ node nZQ is lower than the voltage level of the reference voltage Vref, the first comparator 1216 may output the comparison signal COMP having a logic low value L.

At the second time point t2, the pull-up control circuit 1214 may determine that the comparison signal COMP has a logic low value L. For example, the pull-up control circuit 1214 may determine that the voltage level of the voltage Vzq of the ZQ node nZQ is lower than the voltage level of the reference voltage Vref. The pull-up control circuit 1214 may generate a first pull-up code C1 in response to the comparison signal COMP having a logic low value L. The pull-up control circuit 1214 may transmit a code CODE to the first pull-up circuit 1211. The pull-up control circuit 1214 may provide the first pull-up code C1 to the first pull-up circuit 1211.

The first pull-up circuit 1211 may receive the first pull-up code C1. At the second time point t2, the first pull-up circuit 1211 may update the code CODE. At the second time point t2, the first pull-up circuit 1211 may load the first pull-up code C1. Transistors included in the first pull-up circuit 1211 may be turned on or off in response to the first pull-up code C1. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the second time point t2, the charge injection signal CI may transition from a logic low value L to a logic high value H. The first pull-up circuit 1211 may cause the charge injection signal CI to transition from a logic low value L to a logic high value H while the first pull-up code C1 is being loaded to increase the voltage level of the voltage Vzq of the ZQ node nZQ.

At the third time point t3, because the voltage level of the voltage Vzq of the ZQ node nZQ is greater than the voltage level of the reference voltage Vref, the first comparator 1216 may output the comparison signal COMP having a logic high value H.

At a fourth time point t4, the pull-up control circuit 1214 may determine that the comparison signal COMP has a logic high value H. The pull-up control circuit 1214 may determine that the voltage level of the voltage Vzq of the ZQ node nZQ is higher than the voltage level of the reference voltage Vref. The pull-up control circuit 1214 may generate a code to reduce the voltage level of the voltage Vzq of the ZQ node nZQ. The pull-up control circuit 1214 may generate a second pull-up code C2 in response to the comparison signal COMP having a logic high value H. The pull-up control circuit 1214 may provide the second pull-up code C2 to the first pull-up circuit 1211.

The first pull-up circuit 1211 may receive the second pull-up code C2. At the fourth time point t4, the first pull-up circuit 1211 may load the second pull-up code C2. Transistors included in the first pull-up circuit 1211 may be turned on or off in response to the second pull-up code C2. The voltage level of the voltage Vzq of the ZQ node nZQ may be reduced.

The charge injection control circuit 1219 may receive the comparison signal COMP having a logic high value H. The charge injection control circuit 1219 may generate the charge injection signal CI that transitions from a logic high value H to a logic low value L in response to the comparison signal COMP having a logic high value H. The charge injection control circuit 1219 may provide the charge injection signal CI that transitions from a logic high value H to a logic low value L to the charge injection circuit 1218. At the fourth time point t4, the charge injection signal CI may transition from a logic high value H to a logic low value L.

For example, while the code is being updated to the first pull-up circuit 1211, the charge injection circuit 1218 may inject charges into the ZQ node nZQ. The first pull-up circuit 1211 may cause the charge injection signal CI to transition from a logic high value H to a logic low value L while the second pull-up code C2 is being loaded to decrease the voltage level of the voltage Vzq of the ZQ node nZQ.

At the fifth time point t5, because the voltage level of the voltage Vzq of the ZQ node nZQ is lower than the voltage level of the reference voltage Vref, the first comparator 1216 may output the comparison signal COMP having a logic low value L.

At a sixth time point t6, the pull-up control circuit 1214 may determine that the comparison signal COMP is a logic low value L. For example, the pull-up control circuit 1214 may determine that the voltage level of the voltage Vzq of the ZQ node nZQ is lower than the voltage level of the reference voltage Vref. The pull-up control circuit 1214 may generate a third pull-up code C3 in response to the comparison signal COMP having a logic low value L. The pull-up control circuit 1214 may provide the third pull-up code C3 to the first pull-up circuit 1211.

The first pull-up circuit 1211 may receive the third pull-up code C3. At the sixth time point t6, the first pull-up circuit 1211 may load the third pull-up code C3. Transistors included in the first pull-up circuit 1211 may be turned on or off in response to the third pull-up code C3. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the sixth time point t6, the charge injection signal CI may transition from a logic low value L to a logic high value H. The first pull-up circuit 1211 may cause the charge injection signal CI to transition from a logic low value L to a logic high value H while the third pull-up code C3 is being loaded to increase the voltage level of the voltage Vzq of the ZQ node nZQ.

At the seventh time point t7, because the voltage level of the voltage Vzq of the ZQ node nZQ is lower than the voltage level of the reference voltage Vref, the first comparator 1216 may output the comparison signal COMP having a logic low value L. At the seventh time point t7, the charge injection signal CI may transition from a logic high value H to a logic low value L.

At an eighth time point t8, the pull-up control circuit 1214 may determine that the comparison signal COMP has a logic low value L. For example, the pull-up control circuit 1214 may determine that the voltage level of the voltage Vzq of the ZQ node nZQ is lower than the voltage level of the reference voltage Vref. The pull-up control circuit 1214 may generate a fourth pull-up code C4 in response to the comparison signal COMP having a logic low value L. The pull-up control circuit 1214 may provide the fourth pull-up code C4 to the first pull-up circuit 1211.

The first pull-up circuit 1211 may receive the fourth pull-up code C4. At an eighth time point t8, the first pull-up circuit 1211 may load the fourth pull-up code C4. Transistors included in the first pull-up circuit 1211 may be turned on or off in response to the fourth pull-up code C4. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the eighth time point t8, the charge injection signal CI may transition from a logic low value L to a logic high value H. The first pull-up circuit 1211 may cause the charge injection signal CI to transition from a logic low value L to a logic high value H while the fourth pull-up code C4 is being loaded to increase the voltage level of the voltage Vzq of the ZQ node nZQ.

As described above, when the comparison signal COMP indicates that the voltage level of the ZQ node nZQ is higher than the voltage level of the reference voltage Vref, the charge injection signal CI may transition from a logic high value to a logic low value while a code is being updated to the first pull-up circuit 1211. When the comparison signal COMP indicates that the voltage level of the ZQ node nZQ is lower than the voltage level of the reference voltage Vref, the charge injection signal CI may transition from logic low to logic high while the code is being updated to the first pull-up circuit 1211.

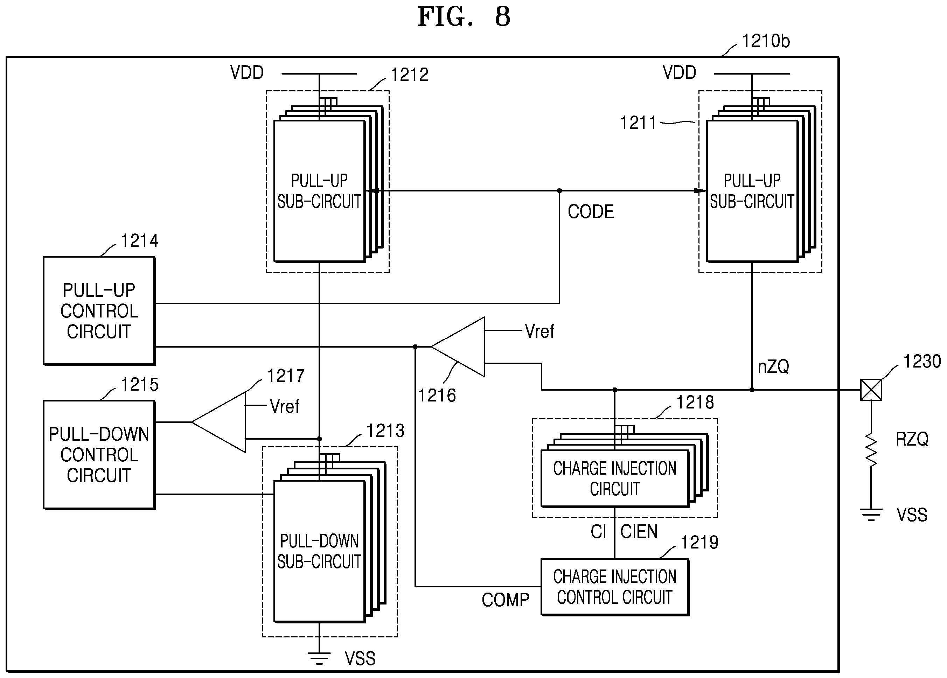

FIG. 8 is a block diagram showing the ZQ calibration circuit of FIG. 1 in more detail.

A ZQ calibration circuit 1210b of FIG. 4 may correspond to the ZQ calibration circuit 1210 of FIG. 1. Referring to FIG. 8, the ZQ calibration circuit 1210b may include the first pull-up circuit 1211, the second pull-up circuit 1212, the pull-down circuit 1213, the pull-up control circuit 1214, the pull-down control circuit 1215, the first comparator 1216, the second comparator 1217, the charge injection circuit 1218, and the charge injection control circuit 1219.

According to an embodiment, the first pull-up circuit 1211 may include a plurality of pull-up sub-circuits. The second pull-up circuit 1212 may include a plurality of pull-up sub-circuits. The pull-down circuit 1213 may include a plurality of pull-down sub-circuits. The charge injection circuit 1218 may include a plurality of charge injection sub-circuits. For example, a plurality of charge injection sub-circuits may be configured as binary size. The ZQ calibration circuit 1210b may adjust the charge injection strength through the plurality of charge injection sub-circuits.

According to an embodiment, the ZQ calibration circuit 1210b may perform a pull-up ZQ calibration operation using a successive approximation register (SAR) search process. The ZQ calibration circuit 1210b may determine the first code using the SAR search process. The SAR search process may refer to a process for finding an optimal termination resistance value by applying a binary search algorithm to the ZQ calibration operation. After setting an initial value, an approximate value may be narrowed down by comparing the initial value with a target value, lowering the initial value when the initial value is too high, and raising the initial value when the initial value is too low, thereby deriving a final value. At each step, a value is adjusted bit-by-bit from a most significant bit MSB to a least significant bit LSB, and an optimal impedance value may be found through binary search. For example, the SAR search process may refer to a process for determining a sub-code of a fourth pull-up sub-circuit PU_SUB4, determining a sub-code of a third pull-up sub-circuit PU_SUB3, determining a sub-code of a second pull-up sub-circuit PU_SUB2, and determining a sub-code of a first pull-up sub-circuit PU_SUB1 in the order stated.

According to an embodiment, the ZQ calibration circuit 1210b may perform a pull-up ZQ calibration operation using a linear search method. The ZQ calibration circuit 1210b may determine the first code using the linear search method.

According to an embodiment, when the ZQ calibration circuit 1210b performs a ZQ calibration operation using an SAR search process, it may search from the MSB to the LSB, and thus the enable signal CIEN may be used to enable a charge injection sub-circuit. For example, the enable signal CIEN may include first to fourth enable signals CIEN1 to CIEN4.

For example, to determine a sub-code of the fourth pull-up sub-circuit PU_SUB4, the charge injection control circuit 1219 may output a fourth enable signal CIEN4 having a logic high value (or active level) and output first to third enable signals CIEN1 to CIEN3 having a logic low value (or inactive level). In response to the fourth enable signal CIEN4 having a logic high value, a fourth charge injection sub-circuit CI_SUB4 may be enabled. In response to the first to third enable signals CIEN1 to CIEN3 having a logic low value, first to third charge injection sub-circuits CI_SUB1 to CI_SUB3 may be disabled.

According to an embodiment, the enable signal CIEN (or any one of the first to fourth enable signals CIEN1 to CIEN4) may be enabled while a code is being updated to the first pull-up circuit 1211. The enable signal CIEN (or any one of the first to fourth enable signals CIEN1 to CIEN4) may be enabled when a code is updated to the first pull-up circuit 1211.

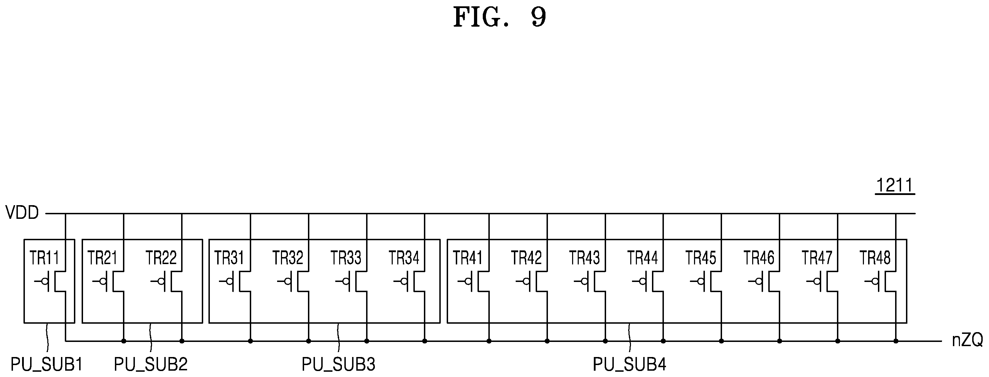

FIG. 9 is a circuit diagram showing the first pull-up circuit of FIG. 8 in more detail.

Referring to FIGS. 8 and 9, the first pull-up circuit 1211 may include a plurality of pull-up sub-circuits, for example a first pull-up sub-circuit PU_SUB1, a second pull-up sub-circuit PU_SUB2, a third pull-up sub-circuit PU_SUB3, and a fourth pull-up sub-circuit PU_SUB4. However, embodiments are not limited thereto, and the number of pull-up sub-circuits included in the first pull-up circuit 1211 may increase or decrease according to embodiments. For example, the number of pull-up sub-circuits included in the first pull-up circuit 1211 may be equal to the number of a plurality of bits included in a code, or the length of the plurality of bits.

According to an embodiment, a k-th pull-up sub-circuit PU_SUBk may include 2^{*k*-1} transistors. Here, k may be a natural number. For example, k may be less than or equal to the number of pull-up sub-circuits included in the first pull-up circuit 1211. According to embodiments, k may be greater than 1 and less than or equal to n. As an example, n may refer to the number of bits included in a code. For example, transistors included in a pull-up sub-circuit may be PMOS transistors. However, embodiments are not limited thereto, and the pull-up sub-circuit may be implemented with a PMOS transistor, an NMOS transistor, or a combination of a PMOS transistor and an NMOS transistor.

The first pull-up sub-circuit PU_SUB1 may include a transistor TR11. The transistor TR11 may be connected between the power node and the ZQ node nZQ. The transistor TR11 may be turned on/off based on a code.

The second pull-up sub-circuit PU_SUB2 may include transistors TR21 and TR22. The transistors TR21 and TR22 may be connected between the power node and the ZQ node nZQ. The transistors TR21 and TR22 may each be turned on/off based on a code.

The third pull-up sub-circuit PU_SUB3 may include transistors TR31, TR32, TR33, and TR34. Transistors TR31, TR32, TR33, and TR34 may be connected between the power node and the ZQ node nZQ. Each of the transistors TR31, TR32, TR33, and TR34 may be turned on/off based on a code.

The fourth pull-up sub-circuit PU_SUB4 may include transistors TR41, TR42, TR43, TR44, TR45, TR46, TR47, and TR48. Transistors TR41, TR42, TR43, TR44, TR45, TR46, TR47, and TR48 may each be connected between the power node and the ZQ node nZQ. The transistors TR41, TR42, TR43, TR44, TR45, TR46, TR47, and TR48 may each be turned on/off based on a code.

The second pull-up circuit 1212 may be configured similarly or identically to the first pull-up circuit 1211. Pull-down sub-circuits included in the pull-down circuit 1213 may be configured similarly or identically to pull-up sub-circuits included in the first pull-up circuit 1211. Redundant or duplicative descriptions thereof are omitted.

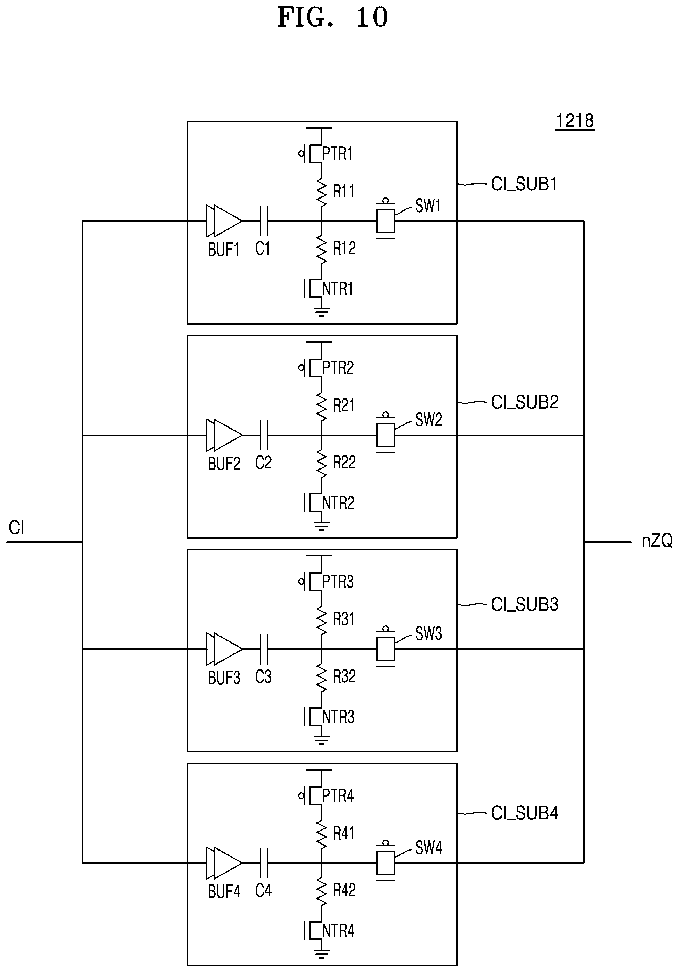

FIG. 10 is a circuit diagram showing the charge injection circuit of FIG. 8 in more detail.

Referring to FIG. 8 and FIG. 10, the charge injection circuit 1218 may include a plurality of charge injection sub-circuits. According to an embodiment, the charge injection circuit 1218 may include a first charge injection sub-circuits CI_SUB1, a second charge injection sub-circuit CI_SUB2, a third charge injection sub-circuit CI_SUB3, and a fourth charge injection sub-circuit CI_SUB4. However, embodiments are not limited thereto, and the number of charge injection sub-circuits included in the charge injection circuit 1218 may be reduced or increased according to embodiments.

According to an embodiment, the number of charge injection sub-circuits included in the charge injection circuit 1218 may be equal to the number of pull-up sub-circuits included in the first pull-up circuit 1211. According to an embodiment, the number of charge injection sub-circuits included in the charge injection circuit 1218 may be equal to the number of bits constituting a code.

According to an embodiment, the first to fourth charge injection sub-circuits CI_SUB1 to CI_SUB4 may correspond to the first to fourth pull-up sub-circuits PU_SUB1 to PU_SUB4, respectively. For example, a first charge injection sub-circuit CI_SUB1 may correspond to the first pull-up sub-circuit PU_SUB1, a second charge injection sub-circuit CI_SUB2 may correspond to the second pull-up sub-circuit PU_SUB2, a third charge injection sub-circuit CI_SUB3 may correspond to the third pull-up sub-circuit PU_SUB3, and the fourth charge injection sub-circuit CI_SUB4 may correspond to the fourth pull-up sub-circuit PU_SUB4.

According to an embodiment, the configuration of the charge injection sub-circuit may be similar or identical to that of the charge injection circuit of FIG. 5D. However, embodiments are not limited thereto, and the charge injection sub-circuit may correspond to any one of the charge injection circuits of FIGS. 5A to 5D. In the example described below, the charge injection sub-circuit may correspond to the charge injection circuit 1218d of Fig. 5D.

According to an embodiment, the charge injection circuit 1218 may receive the charge injection signal CI from the charge injection control circuit 1219. According to an embodiment, the charge injection circuit 1218 may receive the enable signal CIEN from the charge injection control circuit 1219. According to an embodiment, the charge injection circuit 1218 may receive the inverted enable signal CIENB from the charge injection control circuit 1219.

For example, the enable signal CIEN may include a first enable signal CIEN1, a second enable signal CIEN2, a third enable signal CIEN3, and a fourth enable signal CIEN4. The inverted enable signal CIENB may include a first inverted enable signal CIEN1B, a second inverted enable signal CIEN2B, a third inverted enable signal CIEN3B, and a fourth inverted enable signal CIENB4. For example, a first enable signal CIEN1 and a first inverted enable signal CIENB1 may correspond to the first charge injection sub-circuit CI_SUB1. The first charge injection sub-circuit CI_SUB1 may perform a charge injection operation in response to the first enable signal CIEN1 and the first inverted enable signal CIENB1. The second charge injection sub-circuit CI_SUB2 may perform a charge injection operation in response to the second enable signal CIEN2 and the second inverted enable signal CIENB2. The third charge injection sub-circuit CI_SUB3 may perform a charge injection operation in response to the third enable signal CIEN3 and the third inverted enable signal CIENB3. The fourth charge injection sub-circuit CI_SUB4 may perform a charge injection operation in response to the fourth enable signal CIEN4 and the fourth inverted enable signal CIENB4.

The first charge injection sub-circuit CI_SUB1 may include a buffer BUF1, a capacitor C1, a first transistor PTR1, a second transistor NTR1, a first resistor R11, a second resistor R12, and a switch SW1. The first charge injection sub-circuit CI_SUB1 may receive the charge injection signal CI, the first enable signal CIEN1, and the first inverted enable signal CIENB1 from the charge injection control circuit 1219.

The switch SW1 may be connected between the ZQ node nZQ and the capacitor C1. The capacitor C1 may be connected between the buffer BUF 1 and the switch SW1. The buffer BUF1, the capacitor C1, and the switch SW1 may be connected in series. An output of the buffer BUF1 may be connected to the capacitor C1. The buffer BUF1 may receive the charge injection signal CI from the charge injection control circuit 1219. The buffer BUF1 may transfer the charge injection signal CI to the capacitor C1.

The switch SW1 may operate in response to the first enable signal CIEN1 or the first inverted enable signal CIENB1. According to an embodiment, in response to the first enable signal CIEN1 having an enabling level (e.g., an active level and/or a level corresponding to a logic high value H) and the first inverted enable signal CIENB1 of a disabling level (e.g., an inactive level and/or a level corresponding to a logic low value L), the switch SW1 may be turned on. As the switch SW1 is turned on, the capacitor C1 and the ZQ node nZQ may be electrically connected to each other. According to an embodiment, in response to the first enable signal CIEN1 having a disabling level and the first inverted enable signal CIENB1 having an enabling level, the switch SW1 may be turned off. As the switch SW1 is turned off, the capacitor C1 and the ZQ node nZQ may be electrically disconnected.

The first transistor PTR1 may be connected between a power node to which the power voltage VDD is applied and the first resistor R11. The first transistor PTR1 may operate in response to the first enable signal CIEN1. The first transistor TR1 may be a PMOS transistor. However, embodiments are not limited thereto.

According to an embodiment, in response to the first enable signal CIEN1 having an inactive level, the first transistor PTR1 may be turned on. The first transistor PTR1 may be turned on to electrically connect a power node to which a power voltage VDD is applied and the first resistor R11. The first transistor PTR1 may be turned off in response to the first enable signal CIEN1 having an active level. The first transistor PTR1 may be turned off to electrically disconnect a power node to which a power voltage VDD is applied and the first resistor R11.

The first resistor R11 may be connected between the first transistor PTR1 and the ZQ node nZQ. The first resistor R11 may be connected between the first transistor PTR1 and the second resistor R12. The second resistor R12 may be connected between the ZQ node nZQ and the second transistor NTR1. The second resistor R12 may be connected between the first resistor R11 and the second transistor NTR1.

According to an embodiment, the resistance value of the first resistor R11 may be the same as the resistance value of the second resistor R12. According to an embodiment, the resistance value of the first resistor R11 and the resistance value of the second resistor R12 may be different from each other.

The second transistor NTR1 may be connected between a ground node to which the ground voltage VSS is applied and the second resistor R12. The second transistor NTR1 may operate in response to the first inverted enable signal CIENB1. The second transistor NTR1 may be an NMOS transistor. However, embodiments are not limited thereto.

According to an embodiment, in response to the first inverted enable signal CIENB1 having an active level, the second transistor NTR1 may be turned on. The second transistor NTR1 may be turned on to electrically connect a ground node to which the ground voltage VSS is applied and the second resistor R12. In response to the first inverted enable signal CIENB1 having an inactive level, the second transistor NTR1 may be turned off. The second transistor NTR1 may be turned off to electrically disconnect the ground node to which the ground voltage VSS is applied and the second resistor R12.

The second charge injection sub-circuit CI_SUB2 may include a buffer BUF2, a capacitor C2, a first transistor PTR2, a second transistor NTR2, a first resistor R21, a second resistor R22, and a switch SW2. The second charge injection sub-circuit CI_SUB2 may receive the charge injection signal CI, the second enable signal CIEN2, and the second inverted enable signal CIENB2 from the charge injection control circuit 1219.

The switch SW2 may be connected between the ZQ node nZQ and the capacitor C2. The capacitor C2 may be connected between the buffer BUF2 and the switch SW2. The buffer BUF2, the capacitor C2, and the switch SW2 may be connected in series. An output of the buffer BUF2 may be connected to the capacitor C2. The buffer BUF2 may receive the charge injection signal CI from the charge injection control circuit 1219. The buffer BUF2 may transfer the charge injection signal CI to the capacitor C2.

The switch SW2 may operate in response to the second enable signal CIEN2 or the second inverted enable signal CIENB2. According to an embodiment, in response to the second enable signal CIEN2 having an enabling level and the second inverted enable signal CIENB2 having a disabling level, the switch SW2 may be turned on. As the switch SW2 is turned on, the capacitor C1 and the ZQ node nZQ may be electrically connected to each other. According to an embodiment, in response to the second enable signal CIEN2 having a disabling level and the second inverted enable signal CIENB2 having an enabling level, the switch SW2 may be turned off. As the switch SW2 is turned off, the capacitor C2 and the ZQ node nZQ may be electrically disconnected.

The first transistor PTR2 may be connected between a power node to which the power voltage VDD is applied and the first resistor R21. The first transistor PTR2 may operate in response to the second enable signal CIEN2. The first transistor PTR2 may be a PMOS transistor. However, embodiments are not limited thereto.

According to an embodiment, in response to the second enable signal CIEN2 having an inactive level, the first transistor PTR2 may be turned on. The first transistor PTR2 may be turned on to electrically connect a power node to which a power voltage VDD is applied and the first resistor R21. The first transistor PTR2 may be turned off in response to the second enable signal CIEN2 having an active level. The first transistor PTR2 may be turned off to electrically disconnect a power node to which a power voltage VDD is applied and the first resistor R21.

The first resistor R21 may be connected between the first transistor PTR2 and the ZQ node nZQ. The first resistor R21 may be connected between the first transistor PTR2 and the second resistor R22. The second resistor R22 may be connected between the ZQ node nZQ and a second transistor NTR2. The second resistor R22 may be connected between the first resistor R21 and the second transistor NTR2.

According to an embodiment, the resistance value of the first resistor R21 may be the same as the resistance value of the second resistor R22. According to an embodiment, the resistance value of the first resistor R21 and the resistance value of the second resistor R22 may be different from each other.

The second transistor NTR2 may be connected between a ground node to which the ground voltage VSS is applied and the second resistor R22. The second transistor NTR2 may operate in response to the second inverted enable signal CIENB2. The second transistor NTR2 may be an NMOS transistor. However, embodiments are not limited thereto.

According to an embodiment, in response to the second inverted enable signal CIENB2 having an active level, the second transistor NTR2 may be turned on. The second transistor NTR2 may be turned on to electrically connect a ground node to which the ground voltage VSS is applied and the second resistor R22. In response to the first inverted enable signal CIENB1 having an inactive level, the second transistor NTR2 may be turned off. The second transistor NTR2 may be turned off to electrically disconnect the ground node to which the ground voltage VSS is applied and the second resistor R22.

The third charge injection sub-circuit CI_SUB3 may include a buffer BUF3, a capacitor C3, a first transistor PTR3, a second transistor NTR3, a first resistor R31, a second resistor R32, and a switch SW3. The third charge injection sub-circuit CI_SUB3 may receive the charge injection signal CI, the third enable signal CIEN3, and the third inverted enable signal CIENB3 from the charge injection control circuit 1219.

The switch SW3 may be connected between the ZQ node nZQ and the capacitor C3. The capacitor C3 may be connected between the buffer BUF3 and the switch SW3. The buffer BUF3, the capacitor C3, and the switch SW3 may be connected in series. An output of the buffer BUF3 may be connected to the capacitor C3. The buffer BUF3 may receive the charge injection signal CI from the charge injection control circuit 1219. The buffer BUF3 may transfer the charge injection signal CI to the capacitor C3.

The switch SW3 may operate in response to the third enable signal CIEN3 or the third inverted enable signal CIENB3. According to an embodiment, in response to the third enable signal CIEN3 having an enabling level and the third inverted enable signal CIENB3 having a disabling level, the switch SW3 may be turned on. As the switch SW3 is turned on, the capacitor C3 and the ZQ node nZQ may be electrically connected to each other. According to an embodiment, in response to the third enable signal CIEN3 having a disabling level and the third inverted enable signal CIENB3 having an enabling level, the switch SW3 may be turned off. As the switch SW3 is turned off, the capacitor C3 and the ZQ node nZQ may be electrically disconnected.

The first transistor PTR3 may be connected between a power node to which the power voltage VDD is applied and the first resistor R31. The first transistor PTR3 may operate in response to the third enable signal CIEN3. The first transistor PTR3 may be a PMOS transistor. However, embodiments are not limited thereto.

According to an embodiment, in response to the third enable signal CIEN3 having an inactive level, the first transistor PTR3 may be turned on. The first transistor PTR3 may be turned on to electrically connect a power node to which a power voltage VDD is applied and the first resistor R31. The first transistor PTR3 may be turned off in response to the third enable signal CIEN3 having an active level. The first transistor PTR3 may be turned off to electrically disconnect a power node to which a power voltage VDD is applied and the first resistor R31.

The first resistor R31 may be connected between the first transistor PTR3 and the ZQ node nZQ. The first resistor R31 may be connected between the first transistor PTR3 and the second resistor R32. The second resistor R32 may be connected between the ZQ node nZQ and the second transistor NTR3. The second resistor R32 may be connected between the first resistor R31 and the second transistor NTR3.

According to an embodiment, the resistance value of the first resistor R31 may be the same as the resistance value of the second resistor R32. According to an embodiment, the resistance value of the first resistor R31 and the resistance value of the second resistor R32 may be different from each other.

The second transistor NTR3 may be connected between a ground node to which the ground voltage VSS is applied and the second resistor R32. The second transistor NTR3 may operate in response to the third inverted enable signal CIENB3. The second transistor NTR3 may be an NMOS transistor. However, embodiments are not limited thereto.

According to an embodiment, in response to the third inverted enable signal CIENB3 having an active level, the second transistor NTR3 may be turned on. The second transistor NTR3 may be turned on to electrically connect a ground node to which the ground voltage VSS is applied and the second resistor R32. In response to the third inverted enable signal CIENB3 having an inactive level, the second transistor NTR3 may be turned off. The second transistor NTR3 may be turned off to electrically disconnect the ground node to which the ground voltage VSS is applied and the second resistor R32.

The fourth charge injection sub-circuit CI_SUB4 may include a buffer BUF4, a capacitor C4, a first transistor PTR4, a second transistor NTR4, a first resistor R41, a second resistor R42, and a switch SW4. The fourth charge injection sub-circuit CI_SUB4 may receive the charge injection signal CI, the fourth enable signal CIEN4, and the fourth inverted enable signal CIENB4 from the charge injection control circuit 1219.

The switch SW4 may be connected between the ZQ node nZQ and the capacitor C4. The capacitor C4 may be connected between the buffer BUF4 and the switch SW4. The buffer BUF4, the capacitor C4, and the switch SW4 may be connected in series. An output of the buffer BUF4 may be connected to the capacitor C4. The buffer BUF4 may receive the charge injection signal CI from the charge injection control circuit 1219. The buffer BUF4 may transfer the charge injection signal CI to the capacitor C4.

The switch SW4 may operate in response to the fourth enable signal CIEN4 or the fourth inverted enable signal CIENB4. According to an embodiment, in response to the fourth enable signal CIEN4 having an enabling level and the fourth inverted enable signal CIENB4 having a disabling level, the switch SW4 may be turned on. As the switch SW4 is turned on, the capacitor C4 and the ZQ node nZQ may be electrically connected to each other. According to an embodiment, in response to the fourth enable signal CIEN4 having a disabling level and the fourth inverted enable signal CIENB4 having an enabling level, the switch SW4 may be turned off. As the switch SW4 is turned off, the capacitor C4 and the ZQ node nZQ may be electrically disconnected.

The first transistor PTR4 may be connected between a power node to which the power voltage VDD is applied and the first resistor R41. The first transistor PTR4 may operate in response to the fourth enable signal CIEN4. The first transistor PTR4 may be a PMOS transistor. However, embodiments are not limited thereto.

According to an embodiment, in response to the fourth enable signal CIEN4 having an inactive level, the first transistor PTR4 may be turned on. The first transistor PTR4 may be turned on to electrically connect a power node to which a power voltage VDD is applied and the first resistor R41. The first transistor PTR4 may be turned off in response to the fourth enable signal CIEN4 having an active level. The first transistor PTR4 may be turned off to electrically disconnect a power node to which a power voltage VDD is applied and the first resistor R41.

The first resistor R41 may be connected between the first transistor PTR4 and the ZQ node nZQ. The first resistor R41 may be connected between the first transistor PTR4 and the second resistor R42. The second resistor R42 may be connected between the ZQ node nZQ and the second transistor NTR4. The second resistor R42 may be connected between the first resistor R41 and the second transistor NTR4.

According to an embodiment, the resistance value of the first resistor R41 may be the same as the resistance value of the second resistor R42. According to an embodiment, the resistance value of the first resistor R41 and the resistance value of the second resistor R42 may be different from each other.

The second transistor NTR4 may be connected between a ground node to which the ground voltage VSS is applied and the second resistor R42. The second transistor NTR4 may operate in response to the fourth inverted enable signal CIENB4. The second transistor NTR4 may be an NMOS transistor. However, embodiments are not limited thereto.

According to an embodiment, in response to the fourth inverted enable signal CIENB4 having an active level, the second transistor NTR4 may be turned on. The second transistor NTR4 may be turned on to electrically connect a ground node to which the ground voltage VSS is applied and the second resistor R42. In response to the fourth inverted enable signal CIENB4 having an inactive level, the second transistor NTR4 may be turned off. The second transistor NTR4 may be turned off to electrically disconnect the ground node to which the ground voltage VSS is applied and the second resistor R42.

According to an embodiment, the first to fourth buffers BUF1 to BUF4 may each include a plurality of inverters. According to an embodiment, the number of inverters included in the first to fourth buffers BUF1 to BUF4 may be different from one another. For example, the number of inverters included in the second buffer BUF2 may be greater than the number of inverters included in the first buffer BUF 1. The number of inverters included in the third buffer BUF3 may be greater than the number of inverters included in the second buffer BUF2. The number of inverters included in the fourth buffer BUF4 may be greater than the number of inverters included in the third buffer BUF3. According to an embodiment, the number of inverters included in the first to fourth buffers BUF1 to BUF4 may be the same.

According to an embodiment, the first to fourth buffers BUF1 to BUF4 may each be implemented using a plurality of transistors. The first to fourth buffers BUF1 to BUF4 may each include a plurality of transistors. According to an embodiment, the widths (or sizes) of the transistors included in each of the first to fourth buffers BUF1 to BUF4 may be different from one another. For example, the width of the transistors included in the second buffer BUF2 may be greater than the width of the transistors included in the first buffer BUF 1. The width of the transistors included in the third buffer BUF3 may be greater than the width of the transistors included in the second buffer BUF2. The width of the transistors included in the fourth buffer BUF4 may be greater than the width of the transistors included in the third buffer BUF3. According to an embodiment, the widths (or sizes) of the transistors included in each of the first to fourth buffers BUF 1 to BUF4 may be the same.

According to an embodiment, the capacitance of each of first to fourth capacitors C1 to C4 may be different from one another. For example, the capacitance of the second capacitor C2 may be greater than the capacitance of the first capacitor C1. The capacitance of the third capacitor C3 may be greater than the capacitance of the second capacitor C2. The capacitance of the fourth capacitor C4 may be greater than the capacitance of the third capacitor C3. According to an embodiment, the capacitances of the first to fourth capacitors C1 to C4 may be the same.

According to an embodiment, the first to fourth switches SW1 to SW4 may each be implemented using a plurality of transistors. The first to fourth switches SW1 to SW4 may each include a plurality of transistors. According to an embodiment, the widths (or sizes) of the transistors included in each of the first to fourth switches SW1 to SW4 may be different from one another. For example, the width of the transistors included in the second switch SW2 may be greater than the width of the transistors included in the first switch SW1. The width of the transistors included in the third switch SW3 may be greater than the width of the transistors included in the second switch SW2. The width of the transistors included in the fourth switch SW4 may be greater than the width of the transistors included in the third switch SW3. According to an embodiment, the widths (or sizes) of the transistors included in each of the first to fourth switches SW1 to SW4 may be the same.

According to an embodiment, the widths (or sizes) of the first transistors PTR1 to PTR4 may be different from one another. For example, the width of the first transistor PTR2 may be greater than the width of the first transistor PTR1. The width of the first transistor PTR3 may be greater than the width of the first transistor PTR2. The width of the first transistor PTR4 may be greater than the width of the first transistor PTR3. According to an embodiment, the widths (or sizes) of the first transistors PTR1 to PTR4 may be the same.

According to an embodiment, the widths (or sizes) of the second transistors NTR1 to NTR4 may be different from one another. For example, the width of the second transistor NTR2 may be greater than the width of the second transistor NTR1. The width of the second transistor NTR3 may be greater than the width of the second transistor NTR2. The width of the second transistor NTR4 may be greater than the width of the second transistor NTR3. According to an embodiment, the widths (or sizes) of the second transistors NTR1 to NTR4 may be the same.

According to an embodiment, the sizes of the first resistors R11, R21, R31, and R41 may be different from one another. According to an embodiment, the sizes of the first resistors R11, R21, R31, and R41 may be the same. According to an embodiment, the sizes of the second resistors R12, R22, R32, and R42 may be different from one another. According to an embodiment, the sizes of the second resistors R12, R22, R32, and R42 may be the same.

According to an embodiment, the ZQ calibration circuit 1210b may adjust the charge injection strength based on memory package type information. The ZQ calibration circuit 1210b may control the voltage change rate of the ZQ node nZQ by controlling the charge injection strength. For example, the ZQ calibration circuit 1210b may optimize the voltage change rate of the ZQ node nZQ.

As described above, the charge injection strength of the charge injection sub-circuits may be configured differently by varying the number of inverters, the width of the transistors, the size of the resistors, etc. The ZQ calibration circuit 1210b may adjust the charge injection strength when performing the ZQ calibration operation using the SAR method.

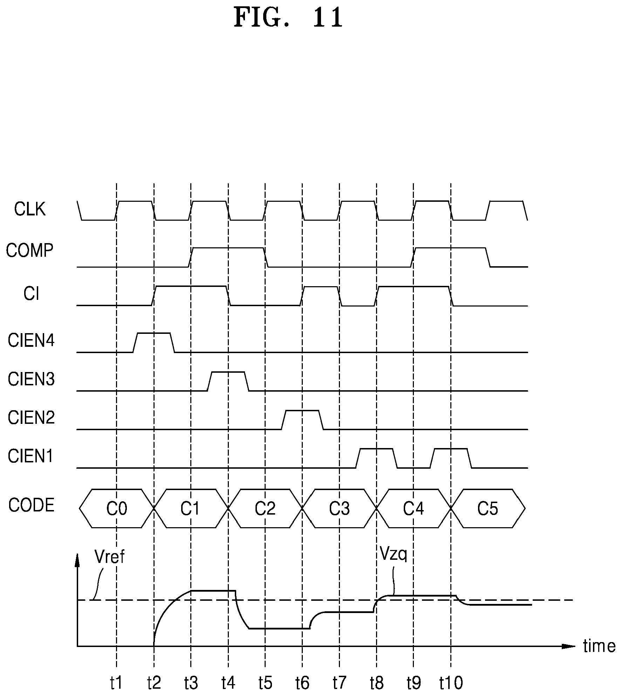

FIG. 11 is a timing diagram illustrating the operation of the ZQ calibration circuit of FIG. 8.

FIG. 11 illustrates an example in which the voltage level of the voltage Vzq of the ZQ node nZQ at the first time point t1 is lower than the voltage level of the reference voltage Vref, the voltage level of the voltage Vzq of the ZQ node nZQ at the third time point t3 is higher than the voltage level of the reference voltage Vref, the voltage level of the voltage Vzq of the ZQ node nZQ at the fifth time point t5 is lower than the voltage level of the reference voltage Vref, the voltage level of the voltage Vzq of the ZQ node nZQ at the seventh time point t7 is lower than the voltage level of the reference voltage Vref, and the voltage level of the voltage Vzq of the ZQ node nZQ at the ninth time point t9 is higher than the voltage level of the reference voltage Vref.

At a first time point t1, because the voltage level of the voltage Vzq of the ZQ node nZQ is lower than the voltage level of the reference voltage Vref, the first comparator 1216 may output the comparison signal COMP having a logic low value L.

At the second time point t2, the pull-up control circuit 1214 may determine that the comparison signal COMP has a logic low value L. The pull-up control circuit 1214 may generate a first pull-up code C1 in response to the comparison signal COMP having a logic low value L. The pull-up control circuit 1214 may provide the first pull-up code C1 to the first pull-up circuit 1211.

The first pull-up circuit 1211 may receive the first pull-up code C1. At the second time point t2, the first pull-up circuit 1211 may update the first pull-up code C1. Transistors included in the first pull-up circuit 1211 may be turned on or off in response to the first pull-up code C1. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the second time point t2, the charge injection signal CI may transition from a logic low value L to a logic high value H. The first pull-up circuit 1211 may cause the charge injection signal CI to transition from a logic low value L to a logic high value H while the first pull-up code C1 is being loaded to increase the voltage level of the voltage Vzq of the ZQ node nZQ.

At the second time point t2, the fourth enable signal CIEN4 may have a logic high value H. In response to the fourth enable signal CIEN4 having a logic high value H, the fourth charge injection sub-circuit CI_SUB4 may perform a charge injection operation. The fourth charge injection sub-circuit CI_SUB4 may be enabled. The fourth charge injection sub-circuit CI_SUB4 may inject charges in the direction in which the voltage level of the ZQ node nZQ increases. At the second time point t2, first, second, and third enable signals CIEN1, CIEN2, and CIEN3 may all have a logic low value L. In response to the first, second, and third enable signals CIEN1, CIEN2, and CIEN3 having a logic low value L, switches SW1, SW2, and SW3 of first, second, and third charge injection sub-circuits CI_SUB1, CI_SUB2, and CI_SUB3 may each be turned off. The first, second, and third charge injection sub-circuits CI_SUB1, CI_SUB2, and CI_SUB3 may not perform charge injection operations. Each of the first, second, and third charge injection sub-circuits CI_SUB1, CI_SUB2, and CI_SUB3 may be disabled.

At the third time point t3, because the voltage level of the voltage Vzq of the ZQ node nZQ is greater than the voltage level of the reference voltage Vref, the first comparator 1216 may output the comparison signal COMP having a logic high value H.

At a fourth time point t4, the pull-up control circuit 1214 may determine that the comparison signal COMP may have a logic high value H. The pull-up control circuit 1214 may generate a second pull-up code C2 in response to the comparison signal COMP having a logic high value H. The pull-up control circuit 1214 may provide the second pull-up code C2 to the first pull-up circuit 1211.

The first pull-up circuit 1211 may receive the second pull-up code C2. At the fourth time point t4, the first pull-up circuit 1211 may load the second pull-up code C2. Transistors included in the first pull-up circuit 1211 may be turned on or off in response to the second pull-up code C2. The voltage level of the voltage Vzq of the ZQ node nZQ may be reduced.

The charge injection control circuit 1219 may receive the comparison signal COMP having a logic high value H. The charge injection control circuit 1219 may generate the charge injection signal CI that transitions from a logic high value H to a logic low value L in response to the comparison signal COMP having a logic high value H. The charge injection control circuit 1219 may provide the charge injection signal CI that transitions from a logic high value H to a logic low value L to the charge injection circuit 1218. At the fourth time point t4, the charge injection signal CI may transition from a logic high value H to a logic low value L.

At the fourth time point t4, the third enable signal CIEN3 may have a logic high value H. In response to the third enable signal CIEN3 having a logic high value H, the third charge injection sub-circuit CI_SUB3 may perform a charge injection operation. The third charge injection sub-circuit CI_SUB3 may be enabled. The third charge injection sub-circuit CI_SUB3 may inject charges in the direction in which the voltage level of the ZQ node nZQ decreases. At the fourth time point t4, first, second, and fourth enable signals CIEN1, CIEN2, and CIEN4 may have a logic low value L. In response to the first, second, and fourth enable signals CIEN1, CIEN2, and CIEN4 having a logic low value L, switches SW1, SW2, and SW4 of first, second, and fourth charge injection sub-circuits CI_SUB1, CI_SUB2, and CI_SUB4 may each be turned off. Each of the first, second, and fourth charge injection sub-circuits CI_SUB1, CI_SUB2, and CI_SUB4 may not perform charge injection operation. Each of the first, second, and fourth charge injection sub-circuits CI_SUB1, CI_SUB2, and CI_SUB4 may be disabled.

At the fifth time point t5, because the voltage level of the voltage Vzq of the ZQ node nZQ is lower than the voltage level of the reference voltage Vref, the first comparator 1216 may output the comparison signal COMP having a logic low value L.

At a sixth time point t6, the pull-up control circuit 1214 may determine that the comparison signal COMP may have a logic low value L. The pull-up control circuit 1214 may generate a third pull-up code C3 in response to the comparison signal COMP having a logic low value L. The pull-up control circuit 1214 may provide the third pull-up code C3 to the first pull-up circuit 1211.

The first pull-up circuit 1211 may receive the third pull-up code C3. At the sixth time point t6, the first pull-up circuit 1211 may update the third pull-up code C3. Transistors included in the first pull-up circuit 1211 may be turned on or off in response to the third pull-up code C3. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the sixth time point t6, the charge injection signal CI may transition from a logic low value L to a logic high value H. The first pull-up circuit 1211 may cause the charge injection signal CI to transition from a logic low value L to a logic high value H while the third pull-up code C3 is being loaded to increase the voltage level of the voltage Vzq of the ZQ node nZQ.

At the sixth time point t6, the second enable signal CIEN2 may have a logic high value H. In response to the second enable signal CIEN2 having a logic high value H, the second charge injection sub-circuit CI_SUB2 may perform a charge injection operation. The second charge injection sub-circuit CI_SUB2 may be enabled. The second charge injection sub-circuit CI_SUB2 may inject charges in the direction in which the voltage level of the ZQ node nZQ increases. At the sixth time point t6, first, third, and fourth enable signals CIEN1, CIEN3, and CIEN4 may have a logic low value L. In response to the first, third, and fourth enable signals CIEN1, CIEN3, and CIEN4 having a logic low value L, switches SW1, SW3, and SW4 of first, third, and fourth charge injection sub-circuits CI_SUB1, CI_SUB3, and CI_SUB4 may each be turned off. The first, third, and fourth charge injection sub-circuits CI_SUB1, CI_SUB3, and CI_SUB4 may not perform charge injection operations. Each of the first, third, and fourth charge injection sub-circuits CI_SUB1, CI_SUB3, and CI_SUB4 may be disabled.

At the seventh time point t7, because the voltage level of the voltage Vzq of the ZQ node nZQ is lower than the voltage level of the reference voltage Vref, the first comparator 1216 may output the comparison signal COMP having a logic low value L.

At an eighth time point t8, the pull-up control circuit 1214 may determine that the comparison signal COMP may have a logic low value L. The pull-up control circuit 1214 may generate a fourth pull-up code C4 in response to the comparison signal COMP having a logic low value L. The pull-up control circuit 1214 may provide the fourth pull-up code C4 to the first pull-up circuit 1211.

The first pull-up circuit 1211 may receive the fourth pull-up code C4. At the eighth time point t8, the first pull-up circuit 1211 may update the fourth pull-up code C4. Transistors included in the first pull-up circuit 1211 may be turned on or off in response to the fourth pull-up code C4. The voltage level of the voltage Vzq of the ZQ node nZQ may be increased.

The charge injection control circuit 1219 may receive the comparison signal COMP having a logic low value L. The charge injection control circuit 1219 may generate the charge injection signal CI that transitions from a logic low value L to a logic high value H in response to the comparison signal COMP having a logic low value L. The charge injection control circuit 1219 may provide the charge injection signal CI that transitions from a logic low value L to a logic high value H to the charge injection circuit 1218. At the eighth time point t8, the charge injection signal CI may transition from a logic low value L to a logic high value H. The first pull-up circuit 1211 may cause the charge injection signal CI to transition from a logic low value L to a logic high value H while the fourth pull-up code C4 is being loaded to increase the voltage level of the voltage Vzq of the ZQ node nZQ.

At the eighth time point t8, the first enable signal CIEN1 may have a logic high value H. In response to the first enable signal CIEN1 having a logic high value H, the first charge injection sub-circuit CI_SUB1 may perform a charge injection operation. The first charge injection sub-circuit CI_SUB1 may inject charges in the direction in which the voltage level of the ZQ node nZQ increases. At the eighth time point t8, second, third, and fourth enable signals CIEN2, CIEN3, and CIEN4 may be a logic low value L. In response to the second, third, and fourth enable signals CIEN2, CIEN3, and CIEN4 having a logic low value L, switches SW2, SW3, and SW4 of second, third, and fourth charge injection sub-circuits CI_SUB2, CI_SUB3, and CI_SUB4 may each be turned off.

At the ninth time point t9, because the voltage level of the voltage Vzq of the ZQ node nZQ is greater than the voltage level of the reference voltage Vref, the first comparator 1216 may output the comparison signal COMP having a logic high value H.

At a tenth time point t10, the pull-up control circuit 1214 may determine that the comparison signal COMP having a logic high value H. The pull-up control circuit 1214 may generate a fifth pull-up code C5 in response to the comparison signal COMP having a logic high value H. The pull-up control circuit 1214 may provide the fifth pull-up code C5 to the first pull-up circuit 1211.

The first pull-up circuit 1211 may receive the fifth pull-up code C5. At the tenth time point t10, the first pull-up circuit 1211 may update the fifth pull-up code C5. Transistors included in the first pull-up circuit 1211 may be turned on or off in response to the fifth pull-up code C5. The voltage level of the voltage Vzq of the ZQ node nZQ may be reduced.

The charge injection control circuit 1219 may receive the comparison signal COMP having a logic high value H. The charge injection control circuit 1219 may generate the charge injection signal CI that transitions from a logic high value H to a logic low value L in response to the comparison signal COMP having a logic high value H. The charge injection control circuit 1219 may provide the charge injection signal CI that transitions from a logic high value H to a logic low value L to the charge injection circuit 1218. At the tenth time point t10, the charge injection signal CI may transition from a logic high value H to a logic low value L.

At the tenth time point t10, the first enable signal CIEN1 may have a logic high value H. In response to the first enable signal CIEN1 having a logic high value H, the first charge injection sub-circuit CI_SUB1 may perform a charge injection operation. The first charge injection sub-circuit CI_SUB1 may inject charges in the direction in which the voltage level of the ZQ node nZQ decreases. At the tenth time point t10, the second, third, and fourth enable signals CIEN2, CIEN3, and CIEN4 may have a logic low value L. In response to the second, third, and fourth enable signals CIEN2, CIEN3, and CIEN4 having a logic low value L, the switches SW2, SW3, and SW4 of the second, third, and fourth charge injection sub-circuits CI_SUB2, CI_SUB3, and CI_SUB4 may each be turned off.

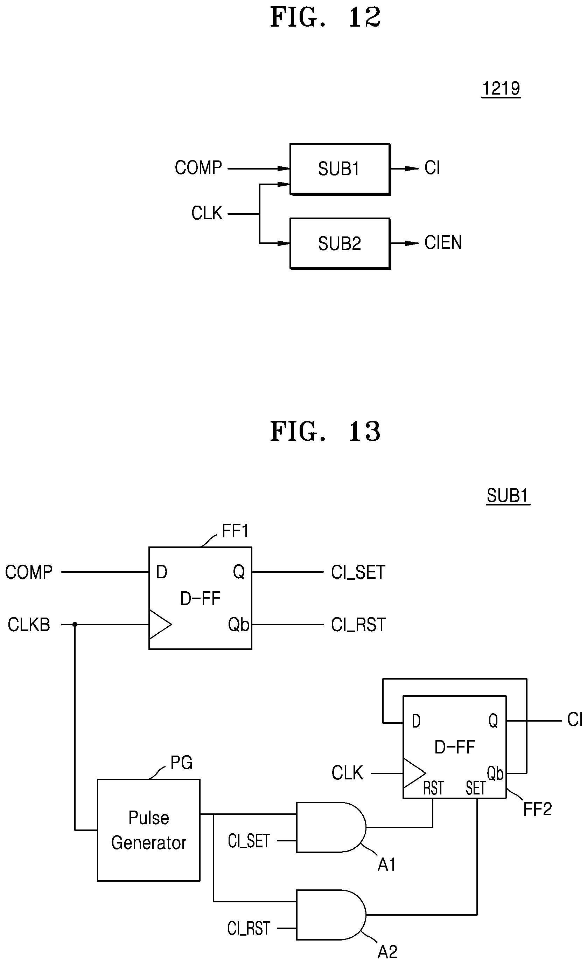

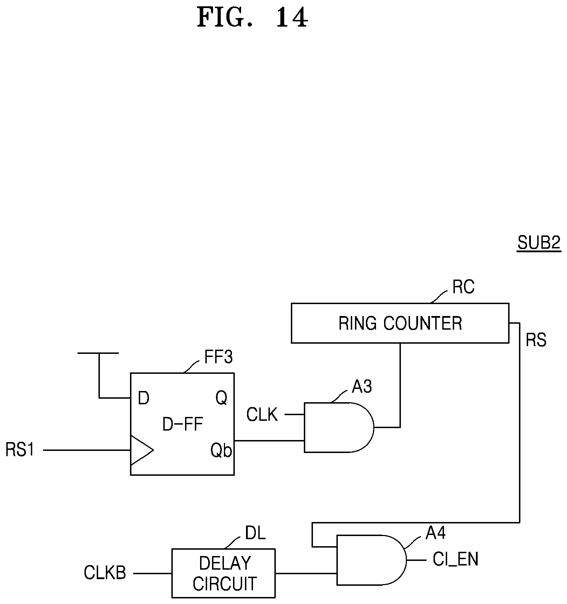

FIG. 12 is a block diagram showing the charge injection control circuit of FIG. 4 in more detail. FIG. 13 is a block diagram showing a first sub-circuit of FIG. 12 in more detail. FIG. 14 is a block diagram showing a second sub-circuit of FIG. 12 in more detail.

Referring to FIGS. 4 and 12, according to an embodiment, the charge injection control circuit 1219 may include a first sub-circuit SUB1 and a second sub-circuit SUB2. The charge injection control circuit 1219 may receive the comparison signal COMP. The charge injection control circuit 1219 may generate the charge injection signal CI based on the comparison signal COMP. The charge injection control circuit 1219 may transmit the charge injection signal CI to the charge injection circuit 1218. The charge injection control circuit 1219 may generate the enable signal CIEN. The charge injection control circuit 1219 may transmit the enable signal CIEN to the charge injection circuit 1218. For example, the enable signal CIEN may include first to fourth enable signals CIEN1 to CIEN4.

The charge injection control circuit 1219 may receive a clock signal CLK. The memory 1200 may further include a clock generator. The clock generator may generate a clock signal CLK. The clock generator may provide the clock signal CLK to the charge injection control circuit 1219.

The first sub-circuit SUB1 may receive the clock signal CLK (or an inverted clock signal CLKB) and the comparison signal COMP. The first sub-circuit SUB1 may generate the charge injection signal CI based on the clock signal CLK and the comparison signal COMP. The first sub-circuit SUB1 may provide the charge injection signal CI to the charge injection circuit 1218.

The second sub-circuit SUB2 may receive the clock signal CLK (or the inverted clock signal CLKB). The second sub-circuit SUB2 may generate the enable signal CIEN (or the inverted enable signal CIENB). The second sub-circuit SUB2 may provide the enable signal CIEN (or the inverted enable signal CIENB) to the charge injection circuit 1218.

Referring to FIG. 13, according to an embodiment, the first sub-circuit SUB 1 may include a first flip-flop FF1, a second flip-flop FF2, a pulse generator PG, a first logic circuit A1, and a second logic circuit A2. For example, the first logic circuit A1 may be an AND gate. The second logic circuit A2 may be an AND gate.

The first flip-flop FF1 may receive the inverted clock signal CLKB and the comparison signal COMP. The first flip-flop FF1 may receive the comparison signal COMP as an input signal D. The first flip-flop FF1 may output a set signal CI_SET as an output signal Q and a reset signal CI_RST as a complementary output signal Qb. The first flip-flop FF1 may provide the level of the comparison signal COMP as the output signal Q at a rising edge of the inverted clock signal CLKB. Based on the comparison signal COMP, the set signal CI_SET and the reset signal CI_RST of the first flip-flop FF1 may be determined.

The pulse generator PG may receive the inverted clock signal CLKB. An output of the pulse generator PG may be connected to an input of the first logic circuit A1. The first logic circuit A1 may receive an output signal from the pulse generator PG. The first logic circuit A1 may receive the set signal CI_SET. The second logic circuit A2 may receive an output signal from the pulse generator PG. The second logic circuit A2 may receive the reset signal CI_RST.

The second flip-flop FF2 may receive the clock signal CLK. The second flip-flop FF2 may receive the complementary output signal Qb of the second flip-flop FF2 as an input signal D. The second flip-flop FF2 may output the level of the input signal D as the output signal Q at a rising edge of the clock signal CLK. The second flip-flop FF2 may receive the output signal of the first logic circuit A1 as the reset signal RST. The second flip-flop FF2 may receive the output signal of the second logic circuit A2 as a set signal SET. The second flip-flop FF2 may output the output signal Q as the charge injection signal CI.

At a time point at which a code is updated to the first pull-up circuit 1211, the first sub-circuit SUB1 may generate and output the charge injection signal CI that causes a charge injection operation. The first sub-circuit SUB1 may transmit the charge injection signal CI to the charge injection circuit 1218.

Referring to FIG. 14, according to an embodiment, the second sub-circuit SUB2 may include a ring counter RC, a third flip-flop FF3, a delay circuit DL, a third logic circuit A3, and a fourth logic circuit A4. The third logic circuit A3 may be an AND gate. The fourth logic circuit A4 may be an AND gate.

The input signal D of the third flip-flop FF3 may be connected to a power node of the power voltage VDD. The third flip-flop FF3 may receive a first output signal RS1 from an output signal RS of the ring counter RC. The third flip-flop FF3 may output the level of the input signal D as the output signal Q at a rising edge of the first output signal RS1. The third flip-flop FF3 may output the complementary output signal Qb. The third logic circuit A3 may receive the clock signal CLK. The third logic circuit A3 may receive the complementary output signal Qb of the third flip-flop FF3. The output of the third logic circuit A3 may be provided to the ring counter RC.

The ring counter RC may receive an output signal of the forth logic circuit A4. The ring counter RC may output the output signal RS. The delay circuit DL may receive the inverted clock signal CLKB. An output of the delay circuit DL may be provided to the fourth logic circuit A4. The fourth logic circuit A4 may receive an output signal of the delay circuit DL. The fourth logic circuit A4 may receive the output signal RS of the ring counter RC. The fourth logic circuit A4 may output an enable signal CI_EN.

The second sub-circuit SUB2 may generate and output the enable signal CIEN at the time point at which a code is updated to the first pull-up circuit 1211. The second sub-circuit SUB2 may enable any one of a plurality of charge injection sub-circuits via the enable signal CIEN. The second sub-circuit SUB2 may enable charge injection sub-circuits in the order from the MSB to the LSB. The second sub-circuit SUB2 may enable only the first enable signal CIEN1 after enabling the first charge injection sub-circuit CI_SUB1 corresponding to the LSB. For example, the second sub-circuit SUB2 may enable the first charge injection sub-circuit CI_SUB1 corresponding to the LSB, and then prevent the fourth charge injection sub-circuit CI_SUB4 corresponding to the MSB from being enabled.

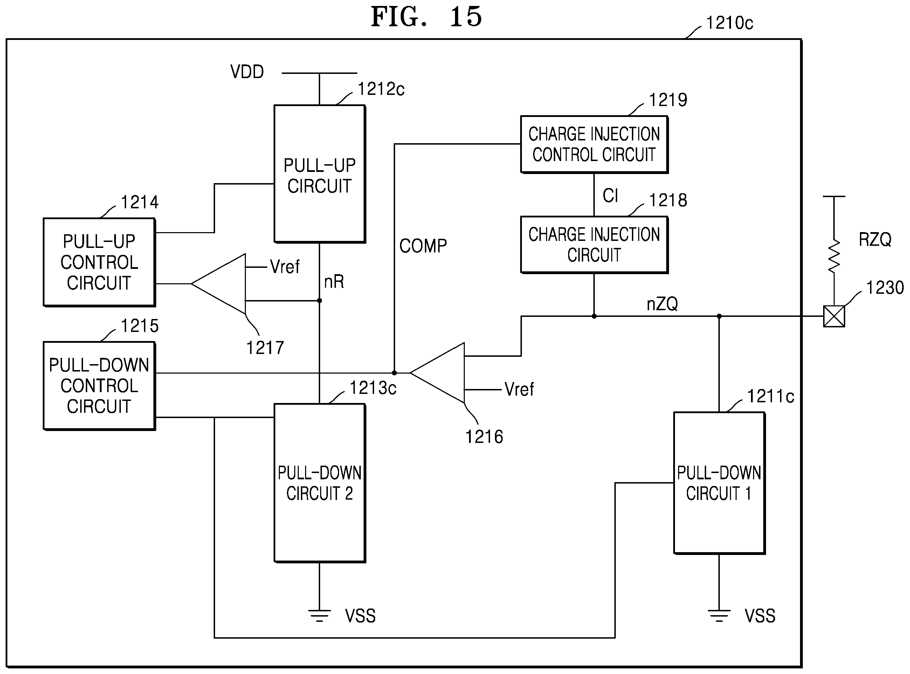

FIG. 15 is a block diagram showing the ZQ calibration circuit of FIG. 1 in more detail.

A ZQ calibration circuit 1210c of FIG. 15 may correspond to the ZQ calibration circuit 1210 of FIG. 1. Referring to FIG. 15, the ZQ calibration circuit 1210c may include a first pull-down circuit 1211c, a pull-up circuit 1212c, a second pull-down circuit 1213c, the pull-up control circuit 1214, the pull-down control circuit 1215, the first comparator 1216, the second comparator 1217, the charge injection circuit 1218, and the charge injection control circuit 1219. For convenience of explanation, redundant or duplicative descriptions of components that are described above may be omitted.

The first pull-down circuit 1211c may be connected between a ground node to which the ground voltage VSS is applied and the ZQ pin 1230. For example, the first pull-down circuit 1211c and the external resistor RZQ may be connected in series between the power node to which the power voltage VDD is applied and a ground node to which the ground voltage VSS is applied. The pull-up circuit 1212c and the second pull-down circuit 1213c may be connected in series between the power node to which the power voltage VDD is applied and a ground node to which the ground voltage VSS is applied.

According to an embodiment, the first pull-down circuit 1211c and the second pull-down circuit 1213c may have substantially the same configuration as the pull-down driver circuit 1222 of FIG. 3. The pull-up circuit 1212c may have substantially the same configuration as the pull-up driver circuit 1221 of FIG. 3.

The first comparator 1216 may compare the voltage level of the ZQ node nZQ connected to the ZQ pin 1230 with the voltage level of the reference voltage Vref and generate a comparison signal COMP based on a comparison result.

The pull-down control circuit 1215 may output a multi-bit count value (e.g., a code) based on the comparison signal COMP of the first comparator 1216. The pull-down control circuit 1215 may provide a code to pull-down circuits (e.g., the first pull-down circuit 1211c and the second pull-down circuit 1213c). The pull-down circuits (e.g., the first pull-down circuit 1211c and the second pull-down circuit 1213c) may increase or decrease the voltage level of the ZQ node nZQ based on the code received from the pull-down control circuit 1215.

The pull-up control circuit 1214 may output a multi-bit count value (e.g., a code) based on a comparison signal of the second comparator 1217. The pull-up control circuit 1214 may provide the code to the pull-up circuit 1212c. The pull-up circuit 1212c may increase or decrease the voltage level of the ZQ node nZQ based on the code received from the pull-up control circuit 1214.

The first comparator 1216 may perform a comparison operation until the voltage level of the ZQ node nZQ and the voltage level of the reference voltage Vref are the same or within a certain value and/or the pull-down control circuit 1215 enters a dither condition in which it oscillates between step-up and step-down. In the pull-down calibration operation, the pull-down control circuit 1215 may provide a code as a second code to each of the pull-down circuits (e.g., the first pull-down circuit 1211c and the second pull-down circuit 1213c) when a comparison result is the same or within a certain value and/or reaches a dither condition. The pull-down termination resistance of the pull-down circuits (e.g., the first pull-down circuit 1211c and the second pull-down circuit 1213c) may be adjusted by the second code.

The second pull-down circuit 1213c may be connected to the pull-up circuit 1212c. The second comparator 1217 may compare the voltage level of a replica node nR between the second pull-down circuit 1213c and the pull-up circuit 1212c with the voltage level of the reference voltage Vref and generate an up/down signal based on a comparison result. The pull-up control circuit 1214 may output a code by stepping up or down based on the up/down signal of the second comparator 1217. A code of the pull-up control circuit 1214 is provided to the pull-up circuit 1212c, and the pull-up circuit 1212c may be controlled in response to receiving the code of the pull-up control circuit 1214.

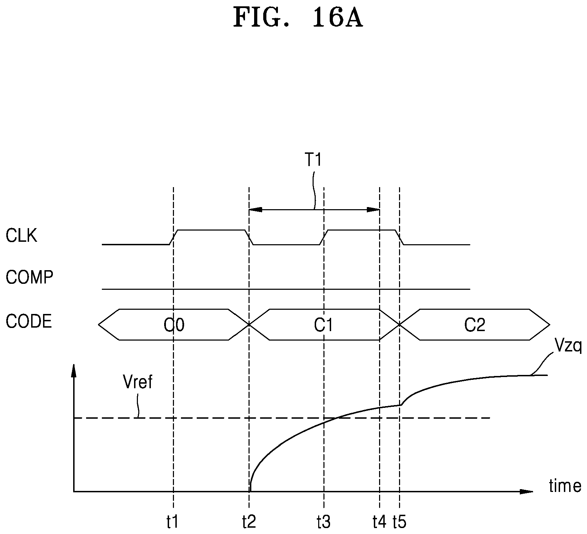

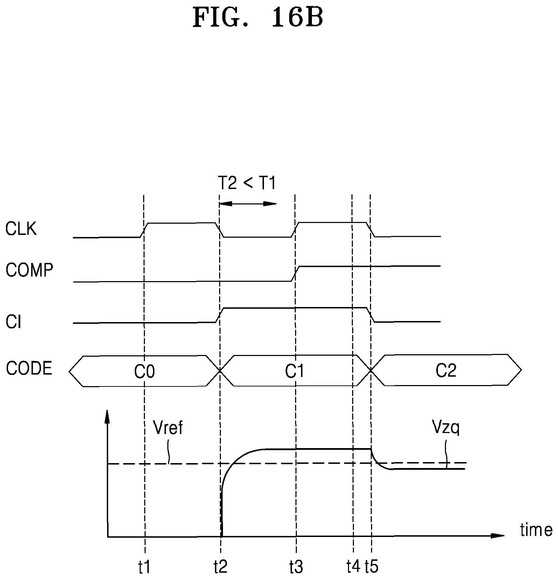

FIGS. 16A and 16B are drawings illustrating the effect of a charge injection operation.

Referring to FIG. 16A, an example of the voltage change of the ZQ node nZQ when a ZQ calibration operation is performed without a charge injection operation is described. Referring to FIG. 16B, an example of the voltage change of the ZQ node nZQ when a ZQ calibration operation is performed while a charge injection operation is being performed is described.

Referring to FIG. 16A, the charge injection control circuit 1219 may output an enable signal as logic low to prevent the charge injection circuit 1218 from performing a charge injection operation. For example, the ZQ calibration circuit 1210 may skip the charge injection operation.

At the first time point t1, because the voltage level of the voltage Vzq of the ZQ node nZQ is lower than the voltage level of the reference voltage Vref, the first comparator 1216 may output the comparison signal COMP having a logic low value L.

At the second time point t2, as the first pull-up code C1 is loaded onto a first pull-up circuit 1211, the voltage Vzq of the ZQ node nZQ may rise. However, the memory device 1300 may include the plurality of memories 1200, and the plurality of memories 1200 may be connected to the ZQ node nZQ. As the loading capacitance value of the ZQ node nZQ increases, the voltage increase rate of the ZQ node nZQ may decrease. Therefore, at the third time point t3, the level of the voltage Vzq of the ZQ node nZQ may be lower than the voltage level of the reference voltage Vref, and, at the fourth time point t4, the level of the voltage Vzq of the ZQ node nZQ may be higher than the voltage level of the reference voltage Vref. The level of the voltage Vzq of the ZQ node nZQ may increase from the second time point t2 to the fourth time point t4. For example, the level of the voltage Vzq of the ZQ node nZQ may increase during a first time T1.

At the third time point t3, the first comparator 1216 may compare the level of the voltage Vzq of the ZQ node nZQ with the voltage level of the reference voltage Vref. As the rate of change of the voltage Vzq of the ZQ node nZQ decreases due to a change in the termination resistance value, the first comparator 1216 may determine at the third time point t3 that the level of the voltage Vzq of the ZQ node nZQ is lower than the voltage level of the reference voltage Vref. Therefore, the first comparator 1216 may output the comparison signal COMP having a logic low value L at the third time point t3.

The pull-up control circuit 1214 may generate the second pull-up code C2 in response to the comparison signal COMP having a logic low value L. The pull-up control circuit 1214may transmit the second pull-up code C2 indicating an increase in the level of the voltage Vzq of the ZQ node nZQ to the first pull-up circuit 1211. At the fifth time point t5, the first pull-up circuit 1211 may load the second pull-up code C2. Therefore, the level of the voltage Vzq of the ZQ node nZQ may increase.

The ZQ calibration circuit 1210a may perform a ZQ calibration operation, such that the level of the voltage Vzq of the ZQ node nZQ is equal to or similar to that of the reference voltage Vref. However, when the voltage change rate of the voltage Vzq of the ZQ node nZQ is slow, a comparison result may be distorted and the termination resistance may be adjusted in an unintended direction.

Referring to FIG. 16B, the charge injection control circuit 1219 may output the enable signal CIEN having a logic high value H, such that the charge injection circuit 1218 performs a charge injection operation. For example, the ZQ calibration circuit 1210 may perform the charge injection operation.

At the first time point t1, because the voltage level of the voltage Vzq of the ZQ node nZQ is lower than the voltage level of the reference voltage Vref, the first comparator 1216 may output the comparison signal COMP having a logic low value L.

At the second time point t2, as the first pull-up code C1 is loaded onto a first pull-up circuit 1211, the voltage Vzq of the ZQ node nZQ may rise. At the second time point t2, the charge injection signal CI may transition from a logic low value L to a logic high value H. Charge may be injected into the ZQ node nZQ in the direction in which the voltage Vzq of the ZQ node nZQ increases. The voltage Vzq of the ZQ node nZQ may rise rapidly. The voltage change rate of the voltage Vzq of the ZQ node nZQ may be increased.

At the third time point t3, the level of the voltage Vzq of the ZQ node nZQ may be higher than the voltage level of the reference voltage Vref. For example, the voltage Vzq of the ZQ node nZQ may increase from the second time point t2 to the third time point t3. The voltage Vzq of the ZQ node nZQ may increase for a second time T2 that is less than the first time T1.

At the third time point t3, the first comparator 1216 may compare the level of the voltage Vzq of the ZQ node nZQ with the voltage level of the reference voltage Vref. As the rate of change of the voltage Vzq of the ZQ node nZQ increases due to a change in the termination resistance value, the first comparator 1216 may determine at the third time point t3 that the level of the voltage Vzq of the ZQ node nZQ is higher than the voltage level of the reference voltage Vref. Therefore, the first comparator 1216 may output the comparison signal COMP having a logic high value H at the third time point t3.

The pull-up control circuit 1214 may generate the third pull-up code C3 in response to the comparison signal COMP having a logic high value H. The pull-up control circuit 1214 may transmit the third pull-up code C3 indicating a decrease in the level of the voltage Vzq of the ZQ node nZQ to the first pull-up circuit 1211. At the fifth time point t5, the first pull-up circuit 1211 may load the third pull-up code C3. Therefore, the level of the voltage Vzq of the ZQ node nZQ may decrease. As the rate of change of the voltage Vzq at the ZQ node nZQ increases through a charge injection operation, a correct comparison result is output, and thus the termination resistance may be adjusted in an intended direction.

According to an embodiment, the voltage slope of the ZQ node nZQ of FIG. 16A may have a value 'a', and the voltage slope of the ZQ node nZQ of FIG. 16B may have value 'b'. The absolute value of the slope of the voltage of the ZQ node nZQ of FIG. 16A may be smaller than the absolute value of the slope of the voltage of the ZQ node nZQ of FIG. 16B (e.g., |a| < |b|). Through a charge injection operation, the absolute value of the slope of the voltage at the ZQ node nZQ may be increased. For example, the voltage change rate of the ZQ node nZQ may be improved through a charge injection operation.

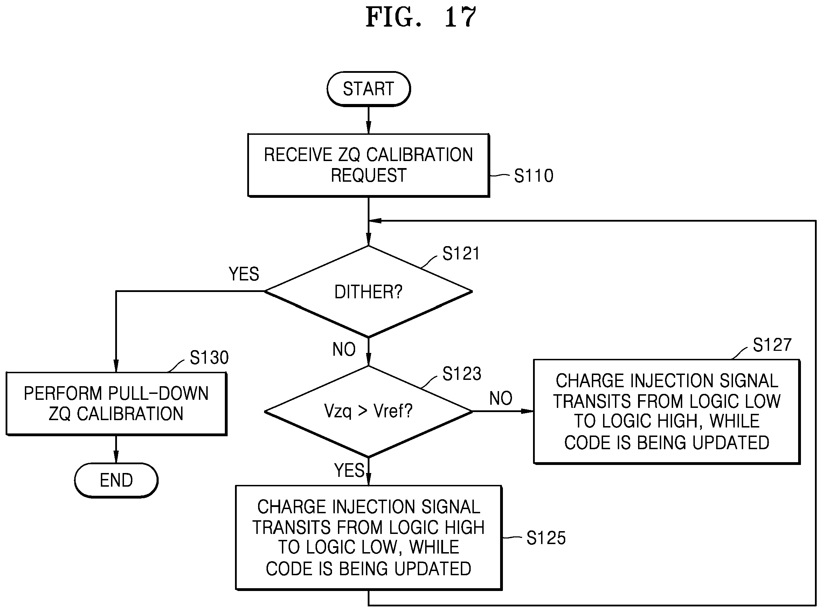

FIG. 17 is a flowchart showing the operation of the ZQ calibration circuit of FIG. 1.

Referring to FIGS. 1 and 17, at operation S110, the ZQ calibration circuit 1210 may receive a ZQ calibration request. The ZQ calibration circuit 1210 may perform a pull-up ZQ calibration operation. Thereafter, the ZQ calibration circuit 1210 may perform a pull-down ZQ calibration operation.

The pull-up ZQ calibration operation may include operations S121 to S127. At operation S121, the ZQ calibration circuit 1210 may determine whether it is currently in a dither state. Based on determining that it is in a dither state, the ZQ calibration circuit 1210 may perform operation S130, and, based on determining that it is not in a dither state, the ZQ calibration circuit 1210 may perform operation S123.

At operation S123, the ZQ calibration circuit 1210 may determine whether the level of the voltage Vzq of the ZQ node nZQ is greater than the voltage level of the reference voltage Vref. Based on determining that the level of the voltage Vzq of the ZQ node nZQ is greater than the voltage level of the reference voltage Vref, the ZQ calibration circuit 1210 may perform operation S125, and, based on determining that the level of the voltage Vzq of the ZQ node nZQ is less than or equal to the voltage level of the reference voltage Vref, the ZQ calibration circuit 1210 may perform operation S127.

At operation S125, while the ZQ calibration circuit 1210 is updating a code of the first pull-up circuit 1211, the charge injection signal CI may transition from a logic high value to a logic low value. Because the level of the voltage Vzq of the ZQ node nZQ is greater than the voltage level of the reference voltage Vref, the ZQ calibration circuit 1210 may generate a code to reduce the level of the voltage Vzq of the ZQ node nZQ. The ZQ calibration circuit 1210 may inject charges in a direction in which the level of the voltage Vzq of the ZQ node nZQ decreases while a code is being loaded to the first pull-up circuit 1211. Afterwards, the ZQ calibration circuit 1210 may perform operation S121 again.

At operation S127, while the ZQ calibration circuit 1210 is updating a code of the first pull-up circuit 1211, the charge injection signal CI may transition from logic low value to logic high value. Because the level of the voltage Vzq of the ZQ node nZQ is smaller than or equal to the voltage level of the reference voltage Vref, the ZQ calibration circuit 1210 may generate a code to increase the level of the voltage Vzq of the ZQ node nZQ. The ZQ calibration circuit 1210 may inject charges in a direction in which the level of the voltage Vzq of the ZQ node nZQ increases while a code is being loaded to the first pull-up circuit 1211. Afterwards, the ZQ calibration circuit 1210 may perform operation S121 again. At operation S130, the ZQ calibration circuit 1210 may perform a pull-down ZQ calibration operation.

While the code is being updated to a driver, additional charges may be injected into the ZQ node nZQ through an AC coupling capacitor. The ZQ calibration circuit 1210 may inject charges in the same direction as the voltage change of the ZQ node nZQ. Therefore, the ZQ calibration circuit 1210 may improve the voltage change rate of the ZQ node nZQ.

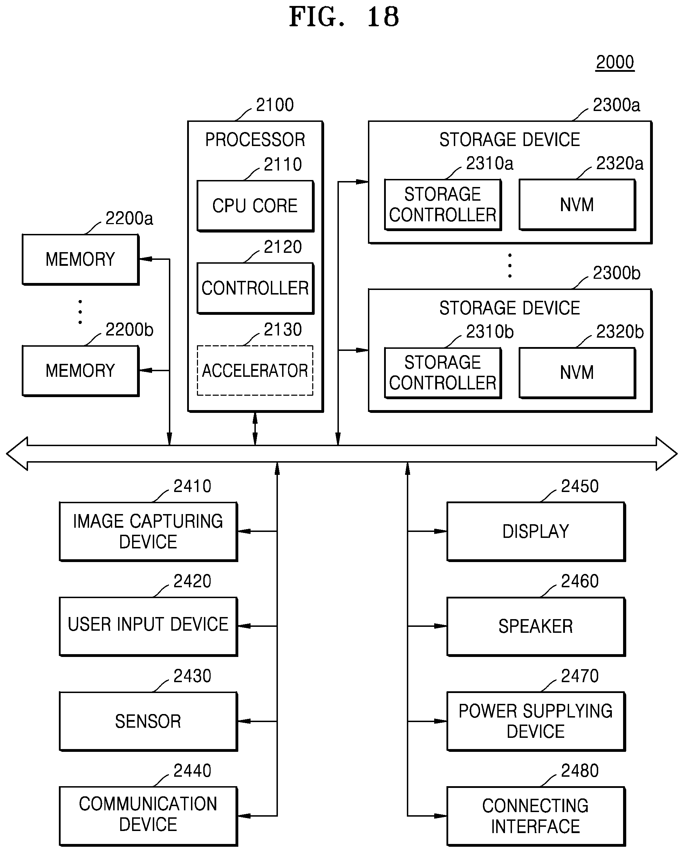

FIG. 18 is a block diagram illustrating a system according to an embodiment.

Referring to FIG. 18, the system 2000 may include a main processor 2100, memories 2200a and 2200b, and storage devices 2300a and 2300b, and may additionally include at least one of an image capturing device 2410, a user input device 2420, a sensor 2430, a communication device 2440, a display 2450, a speaker 2460, a power supplying device 2470, and a connection interface 2480.

The main processor 2100 may control the overall operation of the system 2000, and more particularly, the operations of other components constituting the system 2000. The main processor 2100 may be implemented by a general-purpose processor, a dedicated processor, or an application processor.

The main processor 2100 may include one or more CPU cores 2110 and may further include a controller 2120 for controlling the memories 2200a and 2200b and/or the storage devices 2300a and 2300b.

According to embodiments, the main processor 2100 may further include an accelerator 2130, which is a dedicated circuit for high-speed data operation like AI data operation. The accelerator 2130 may include a (GPU, a neural processing unit (NPU), and/or a data processing unit (DPU) and may also be implemented as a separate chip physically independent from the other components of the main processor 2100.

The memories 2200a and 2200b may be used as the main memory device of the system 2000 and may include volatile memories such as SRAMs and/or DRAMs. However, embodiments are not limited thereto, and the memories 2200a and 2200b may also include non-volatile memories such as flash memories, FRAMs, PRAMs, and/or RRAMs. The memories 2200a and 2200b may be implemented in the same package as the main processor 2100.

The storage devices 2300a and 2300b may function as non-volatile storage devices that store data regardless of whether power is supplied thereto, and may have a relatively large storage capacity compared to the memories 2200a and 2200b. The storage devices 2300a and 2300b may include storage controllers 2310a and 2310b and non-volatile memories (NVMs) 2320a and 2320b that stores data under the control of the storage controllers 2310a and 2310b. The NVMs 2320a and 2320b may include flash memory having a 2-dimensional (2D) structure or a 3-dimensional (3D) V-NAND (vertical NAND) structure, but may also include other types of non-volatile memories like a PRAM and/or an RRAM.

The storage devices 2300a and 2300b may be included in the system 2000 but may be physically separated from the main processor 2100 or may be implemented in the same package as the main processor 2100. Also, the storage devices 2300a and 2300b may be solid state devices (SSDs) or memory cards, and thus the storage devices 2300a and 2300b may be detachably attached to the other components of the system 2000 through an interface such as a connection interface 2480 to be described below. The storage devices 2300a and 2300b may be devices to which standard protocols like universal flash storage (UFS), embedded multi-media card (eMMC), or non-volatile memory express (NVMe) are applied, but are not necessarily limited thereto.

The image capturing device 2410 may capture a still image or a moving picture and may include a camera, a camcorder, and/or a webcam.

The user input device 2420 may receive various types of data input from a user of the system 2000 and may include a touch pad, a keypad, a keyboard, a mouse, and/or a microphone.

The sensor 2430 may sense various types of physical quantities that may be obtained from outside the system 2000 and transform sensed physical quantities into electrical signals. The sensor 2430 may include a temperature sensor, a pressure sensor, an illuminance sensor, a positional sensor, an acceleration sensor, a biosensor, and/or a gyroscope sensor.

The communication device 2440 may transmit and receive signals to and from other devices outside the system 2000 according to various communication protocols. The communication device 2440 may include an antenna, a transceiver, and/or a modem.

The display 2450 and the speaker 2460 may function as output devices that output visual and auditory information to a user of the system 2000, respectively.

The power supplying device 2470 may appropriately convert power supplied from a battery embedded to the system 2000 and/or power supplied from an external power source and supply converted power to the components of the system 2000.

The connection interface 2480 may provide a connection between the system 2000 and an external device, which is capable of being connected to the system 2000 and exchanging data with the system 2000. The connection interface 2480 may be implemented as one of various interface protocols such as advanced technology attachment (ATA), serial ATA (ATA), external SATA (e-SATA ), small computer small interface (SCSI), aerial attached SCSI (SAS), peripheral component interconnection (PCI), PCI express (PCIe), NVM express (NVMe), IEEE 1394, universal serial bus (USB), a secure digital (SD) card, a multi-media card (MMC), an eMMC, UFS, an embedded universal flash storage (eUFS), and a compact flash (CF) card interface.

According to an embodiment, the controller 2120 may be or may correspond to the memory controller 1100 described with reference to FIGS. 1 through 17. According to an embodiment, the memories 2200a and 2200b may be or may correspond to the memory device 1300 described with reference to FIGS. 1 through 17. The memories 2200a and 2200b may include a ZQ calibration circuit. The memories 2200a and 2200b may perform a charge injection operation.

According to an embodiment, the storage controllers 2310a and 2310b may be or may correspond to the memory controller 1100 as described with reference to FIGS. 1 through 17. The NVMs 2320a and 2320b may be or may correspond to the memory device 1300 described with reference to FIGS. 1 through 17. The NVMs 2320a and 2320b may include a ZQ calibration circuit. The NVMs 2320a and 2320b may perform a charge injection operation.

Therefore, the ZQ calibration circuit may inject charges into the ZQ node nZQ based on the comparison signal COMP. Therefore, the ZQ calibration circuit may improve the voltage change rate of the ZQ node.

While some examples have been particularly shown and described above, it will be understood that various changes in form and details may be made therein without departing from the scope of the following claims.

## Claims

1. A memory device (1300), comprising:
a plurality of memories (1200); and
an impedance adjustment resistor (RZQ),
wherein a memory (1200) from among the plurality of memories (1200) comprises:
an impedance adjustment pin (1230) connected to the impedance adjustment resistor (RZQ); and
an impedance adjustment calibration circuit (1210) configured to perform an impedance adjustment calibration operation, wherein the impedance adjustment calibration circuit (1210) comprises:
a driver (1211, 1211c) connected to the impedance adjustment pin (1230) and connected to the impedance adjustment resistor (RZQ) in series; and
a charge injection circuit (1218) comprising a buffer (BUF) and an alternating current coupling capacitor (C),
wherein the charge injection circuit (1218) is connected to the impedance adjustment pin (1230), and is configured to receive a charge injection signal (CI),
wherein, based on a voltage level of an impedance adjustment node (nZQ) connected to the impedance adjustment pin (1230) being higher than a voltage level of a reference voltage (Vref), the charge injection signal (CI) transitions from a logic high value to a logic low value while a code is updated to the driver (1211, 1211c), and
wherein, based on the voltage level of the impedance adjustment node (nZQ) being lower than the voltage level of the reference voltage (Vref), the charge injection signal (CI) transitions from the logic low value to the logic high value while the code is updated to the driver (1211, 1211c).

2. The memory device (1300) of claim 1, wherein the driver (1211, 1211c) comprises a pull-up driver (1211),
wherein the pull-up driver (1211) is connected to a power node (VDD) and the impedance adjustment node (nZQ), and
wherein the impedance adjustment calibration circuit (1210a) further comprises:
a comparator (1216) configured to perform a comparison between a voltage level of the impedance adjustment node (nZQ) and a voltage level of the reference voltage (Vref), and to output a comparison signal (COMP) based on a result of the comparison; and
a pull-up control circuit (1214) configured to generate the code (CODE) based on the comparison signal (COMP), and to provide the code (CODE) to the pull-up driver (1211).

3. The memory device (1300) of claim 2, wherein the impedance adjustment calibration circuit (1210a) further comprises a charge injection control circuit (1219) configured to:
receive the comparison signal (COMP);
generate the charge injection signal (CI) based on the comparison signal (COMP); and
output the charge injection signal (CI) to the charge injection circuit (1218).

4. The memory device (1300) of claim 3, wherein the charge injection control circuit (1219) is further configured to output an enable signal (CIEN) having the logic high value to the charge injection circuit (1218) while the code (CODE) is being updated to the driver (1211).

5. The memory device (1300) of claim 4, wherein the charge injection circuit (1218b) further comprises a switch (SW) connected to the AC coupling capacitor (C) and the impedance adjustment node (nZQ), and
wherein the switch (SW) is activated based on the enable signal (CIEN).

6. The memory device (1300) of claim 4, wherein the charge injection circuit (1218c) further comprises:
a first transistor (TR1) connected to the power node (VDD), wherein the first transistor (TR1) is configured to operate based on the enable signal (CIEN);
a first resistor (R1) connected to the first transistor (TR1) and the impedance adjustment node (nZQ);
a second resistor (R2) connected to the impedance adjustment node (nZQ); and
a second transistor (TR2) connected to the second resistor (R2) and a ground node (VSS), wherein the second transistor (TR2) is configured to operate based on an inverted enable signal (CIENB).

7. The memory device (1300) of claim 4, wherein the charge injection circuit (1218d) further comprises:
a first transistor (TR1) connected the power node (VDD), wherein the first transistor (TR1) is configured to operate based on the enable signal (CIEN);
a first resistor (R1) connected to the first transistor (TR1) and the impedance adjustment node (nZQ);
a second resistor (R2) connected to the impedance adjustment node (nZQ);
a second transistor (TR2) connected to the second resistor (R2) and a ground node (VSS), wherein the second transistor (TR2) is configured to operate based on an inverted enable signal (CIENB); and
a switch (SW) connected to the AC coupling capacitor (C) and the impedance adjustment node (nZQ), wherein the switch (SW) is activated based on the enable signal (CIEN).

8. The memory device (1300) of claim 7, wherein, while the charge injection circuit (1218d) performs a charge injection operation for injecting charges in a direction corresponding to a change direction of a voltage level of the impedance adjustment node (nZQ), the first transistor (TR1) is deactivated, the second transistor is deactivated (TR2), and the switch (SW) is activated.

9. The memory device (1300) of any one of claims 4 to 8, wherein the pull-up driver (1211) comprises a first pull-up sub-circuit (PU_SUB1) and a second pull-up sub-circuit (PU_SUB2),
wherein the charge injection circuit (1218) comprises a first charge injection sub-circuit (CI_SUB1) connected to the impedance adjustment node (nZQ) and a second charge injection sub-circuit (CI_SUB2) connected to the impedance adjustment node (nZQ),
wherein the first charge injection sub-circuit (CI_SUB1) comprises a first buffer (BUF1) and a first capacitor (C1), and
wherein the second charge injection sub-circuit (CI_SUB2) comprises a second buffer (BUF2) and a second capacitor (C2).

10. The memory device (1300) of claim 9, wherein an electrostatic capacitance of the first capacitor (C 1) is different from an electrostatic capacitance of the second capacitor (C2).

11. The memory device (1300) of claim 9 or 10, wherein a number of inverters included in the first buffer (BUF1) is different from a number of inverters included in the second buffer (BUF2).

12. The memory device (1300) of any one of claims 9 to 11, wherein widths of transistors included in the first buffer (BUF1) are different from widths of transistors included in the second buffer (BUF2).

13. The memory device (1300) of any one of claims 9 to 12, wherein the enable signal (CIEN) comprises a first enable signal (CIEN1) and a second enable signal (CIEN2),
wherein the charge injection control circuit (1219) is further configured to:
output the first enable signal (CIEN1) having the logic high value and the second enable signal (CIEN2) having the logic low value during a first period (t8); and
the first enable signal (CIEN1) having the logic low value and the second enable signal (CIEN2) having the logic high value during a second period (t6).

14. The memory device (1300) of claim 13, wherein the first charge injection sub-circuit (CI_SUB1) is configured to perform a charge injection operation during the first period (t8), and,
wherein the second charge injection sub-circuit (CI_SUB2) is configured to perform the charge injection operation during the second period (t6).

15. The memory device (1300) of claim 1, wherein the driver (1211, 1211c) comprises a pull-down driver (1211c),
wherein the pull-down driver (1211c) is connected to a ground node (VSS) and the impedance adjustment node (nZQ), and
wherein the impedance adjustment calibration circuit (1210c) further comprises:
a comparator (1216) configured to perform a comparison between the voltage level of the impedance adjustment node (nZQ) and the voltage level of the reference voltage (Vref), and to output a comparison signal (COMP) based on a result of the comparison; and
a pull-down control circuit (1215) configured to generate the code based on the comparison signal (COMP), and to provide the code to the pull-down driver (1211c).
